(19) Europäisches Patentamt
European Patent Office
Office européen des brevets

(11) **EP 1 887 373 A1**

(12) **EUROPÄISCHE PATENTANMELDUNG**

(43) Veröffentlichungstag:
**13.02.2008 Patentblatt 2008/07**

(51) Int Cl.:
**G01R 33/36** *(2006.01)*

(21) Anmeldenummer: **07015416.6**

(22) Anmeldetag: **07.08.2007**

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK YU**

(30) Priorität: **09.08.2006 DE 102006037196**

(71) Anmelder: **Bruker BioSpin AG**
**8117 Fällanden (CH)**

(72) Erfinder:
• **Schwilch, Arthur**
 **8610 Uster (CH)**
• **Marek, Daniel**
 **5103 Möriken (CH)**
• **Freytag, Nicolas**
 **8122 Binz (CH)**

(74) Vertreter: **Kohler Schmid Möbus**
**Patentanwälte**
**Ruppmannstrasse 27**
**70565 Stuttgart (DE)**

(54) **Passiv gedämpfte Magnetresonanz(=MR)-Detektionsanordnung und Verfahren zur Dämpfung eines HF-Schwingkreises einer solchen MR-Detektionsanordnung**

(57) Eine Magnetresonanz(=MR)-Detektionsanordnung mit mindestens einem HF-Schwingkreis (1) mit einer Induktivität (L), einem Vorverstärker-Modul (2) und einem HF-Empfänger (7), wobei zwischen einem hochohmigen Punkt (M) der Induktivität (L) und einem niederohmigen Anschlusspunkt (A) des HF-Schwingkreises (1) eine reaktive Transformationsschaltung angeschlossen ist, welche als Impedanztransformator wirkt und wobei der niederohmige Anschlusspunkt (A) über eine HF-Leitung (15) mit einem Wellenwiderstand ($R_W$) mit dem Vorverstärker-Modul (2) verbunden ist, ist dadurch gekennzeichnet, dass im Vorverstärker-Modul (2) mindestens eine, der HF-Leitung (15) nachfolgende passive Dämpfungsimpedanz ($Z_{DV},Z_{SV},Z_{DV'},Z_{SV'}$) vorgesehen ist, wobei die passive Dämpfungsimpedanz ($Z_{DV},Z_{SV}, Z_{DV'},Z_{SV'}$) während eines Dämpfungs- und/oder Sendevorgangs mittels einer Schalteinrichtung zu dem Schwingkreis (1) zuschaltbar ist, und wobei der jeweilige Betrag des komplexen Reflexionsfaktors der passiven Dämpfungsimpedanz ($Z_{DV},Z_{SV},Z_{DV'},Z_{SV'}$) bezogen auf den Wellenwiderstand ($R_W$) der HF-Leitung (15) den Wert von 0.5 übersteigt. Auf diese Weise kann eine MR-Detektionsanordnung mit einem umfassenden Dämpfungskonzept realisiert werden, bei dem Sende-, Dämpfungs- und Empfangsvorgang optimiert sind.

**Fig.1**

EP 1 887 373 A1

## Beschreibung

Die Erfindung betrifft eine Magnetresonanz (=MR)-Detektionsanordnung mit mindestens einem HF-Schwingkreis mit einer Induktivität, einem Vorverstärker-Modul und einem HF-Empfänger, wobei zwischen einem hochohmigen Punkt der Induktivität des HF-Schwingkreises und einem niederohmigen Anschlusspunkt des HF-Schwingkreises eine reaktive Transformationsschaltung angeschlossen ist, welche als Impedanztransformator wirkt und wobei der niederohmige Anschlusspunkt des HF-Schwingkreis über eine HF-Leitung mit einem Wellenwiderstand mit dem Vorverstärker-Modul verbunden ist.

Eine derartige Anordnung ist bereits aus [4] bekannt.

Ein Sensor eines NMR-Spektrometers besteht im Wesentlichen aus einem Hochfrequenz(= HF)-Schwingkreis, der eng um eine NMR-Messprobe angeordnet ist. Normalerweise arbeitet in einem ersten Zeitabschnitt, dem so genannten Sendevorgang, der HF-Schwingkreis als Sendeantenne. Dem HF-Schwingkreis wird ein starker, pulsförmiger HF-Strom zugeführt, der seinerseits ein starkes HF-Feld in der NMR-Messprobe erzeugt und die darin enthaltenen Kernspins anregt. In einem anschließenden zweiten Zeitabschnitt, dem so genannten Empfangsvorgang, arbeitet der HF-Schwingkreis als Detektor und empfängt das von den Kernspins abgestrahlte HF-Feld, das so genannte FID-Signal (FID = Free Induction Decay), das über eine HF-Leitung dem Vorverstärker mit seinem Anpassungsnetzwerk zugeführt wird.

Um das Signal-zu-Rausch-Verhältnis (= SINO) des Kernresonanzsignals (= NMR-Signals) zu optimieren, muss der Vorverstärker an die HF-Leitung rauschangepasst werden. Dies kann zur Folge haben, dass das eine Ende der HF-Leitung, welches zum Vorverstärker führt, nicht mit dem Wellenwiderstand der HF-Leitung abgeschlossen wird, und dies kann wiederum zur Folge haben, dass während des Empfangsvorganges stehende Wellen in der HF-Leitung entstehen [4]. Diese beeinflussen den Gütewert (= Q-Wert) sowie die Resonanzfrequenz des belasteten HF-Schwingkreises, so dass die HF-Leitung und das Anpassungsnetzwerk des Vorverstärkers ebenfalls als Teile des HF-Schwingkreises betrachtet werden müssen.

Um während des Empfangsvorganges eine hohe Signalempfindlichkeit, d.h. ein hohes SINO des FID-Signals zu erreichen, muss unter anderem der serielle Verlustwiderstand der Induktivität des HF-Schwingkreises möglichst klein sein, damit das in diesem entstehende thermische Rauschen ebenfalls möglichst klein wird. Deshalb werden heute kryogen gekühlte HF-Schwingkreise aus normalleitenden sowie auch aus Hochtemperatur-Supraleiter(=HTSC - High Temperature Super Conductor)-Materialien eingesetzt. Das führt zu einer starken Verringerung des Rauschens, aber gleichzeitig auch zu einer beträchtlichen Erhöhung des Q-Wertes des unbelasteten HF-Schwingkreises (Schwingkreis ohne Kabel und Anpassungsnetzwerk).

HF-Schwingkreise mit hohen Q-Werten haben jedoch den Nachteil, dass während des Sendevorganges die pulsförmige Sendeenergie nicht sofort vom HF-Schwingkreis aufgenommen oder aus diesem wieder entfernt werden kann, denn der HF-Schwingkreis benötigt dazu eine bestimmte Einschwing- resp. Ausschwingzeit, die umso länger ist, je höher dieser Q-Wert ist. Wie leicht gezeigt werden kann, weist ein leistungsangepasster Schwingkreis die doppelte Dämpfung bzw. die halbe Zeitkonstante als ein frei schwingender auf. Diese doppelte Dämpfung bestimmt normalerweise das Ein- und Ausschwingverhalten des Schwingkreises. Dieses ist jedoch beispielsweise für NMR-Spektroskopie-Anwendungen nicht ausreichend.

Es ist vor allem der Ausschwingvorgang, der kritisch ist, denn dieser überdeckt normalerweise den Anfang des Empfangsvorganges und damit auch den Anfang des FID-Signals, und verhindert dadurch eine genaue zeitliche Trennung zwischen Sende- und Empfangsvorgang. Es ist deshalb zweckmäßig, einen dritten Zeitabschnitt zu definieren, der im Weiteren als Dämpfungsvorgang bezeichnet wird, und der zwischen dem Sende- und dem Empfangsvorgang liegt.

Erschwerend kommt hinzu, dass heutige NMR-Magnetsysteme mit supraleitenden Spulen aufgebaut sind, und dass dadurch die Platzverhältnisse innerhalb der Raumtemperaturbohrung (= RT)-Bohrung), d.h. innerhalb des zur Verfügung stehenden Messraumes, sehr eng sind. Das führt dazu, dass der HF-Schwingkreis vom Vorverstärker örtlich getrennt und mit einer HF-Leitung elektrisch verbunden werden muss. Infolge der hohen NMR-Frequenzen bei den heutigen NMR-Spektrometern, kann die Länge dieser HF-Leitung ein Mehrfaches der Wellenlänge der NMR-Frequenz betragen. Die HF-Leitung kann jedoch, abhängig von der Konstruktion und der NMR-Frequenz auch sehr kurz gegenüber der Wellenlänge sein.

Im Folgenden werden die in den drei definierten Zeitabschnitten auftretenden Probleme, Anordnungen und Eigenschaften näher beschrieben. Insbesondere wird auf die Problematik eingegangen, die bei HF-Schwingkreisen mit sehr hohen Q-Werten entsteht.

### *Sendevorgang*

Beim Sendevorgang wird die Breite des NMR-Spektrums, die angeregt werden kann, durch die verfügbare Bandbreite des Sendesystems, und damit insbesondere durch die Bandbreite des zum Senden verwendeten HF-Schwingkreises begrenzt. Ein sehr hoher Q-Wert des HF-Schwingkreises hat zur Folge, dass die Bandbreite des HF-Schwingkreises möglicherweise zu gering ist, um den gewünschten Frequenzbereich der magnetischen Spins anzuregen. Hier müssen Möglichkeiten gefunden werden, um trotzdem die erforderlichen Anregungsbandbreiten des NMR-Spektrums zu erreichen.

## *Dämpfungsvorgang*

Während des Dämpfungsvorgangs müssen zusätzliche Maßnahmen eingesetzt werden, um den exponentiell abklingenden Ausschwingvorgang des Spulenstromes als Folge des Sendepulses so stark wie möglich zu verkürzen, so dass mit der Aufnahme des FID-Signals so schnell wie möglich begonnen werden kann. Dies ist sehr wichtig, denn der Anfang des FID-Signals enthält unter anderem die sehr wichtige Information bezüglich der Anfangsphase der einzelnen Resonanzfrequenzen, die im FID-Signal enthalten sind. Geht diese Information verloren, dann entstehen im NMR-Spektrum, das nach der Fourier-Transformation (= FT) zur Verfügung steht, Verzerrungen der Basislinie sowie der Form der NMR-Resonanzlinien. Zudem ist die Berechnung des Integrals über die einzelnen NMR-Linien nicht mehr korrekt zu ermitteln.

Neben den Verzerrungen des Spektrums entsteht bei einem langen Ausschwingvorgang zusätzlich noch ein unerwünschter SINO-Verlust, da während der Zeit des Ausschwingvorganges kein FID-Signal aufgenommen werden kann, d.h. ein Teil des FID-Signals verloren geht.

Wie stark der Ausschwingvorgang abgeklungen sein muss, bis der Empfangsvorgang gestartet werden kann, hängt in erste Linie vom Vorverstärker und der nachfolgenden Empfangskette ab. Diese müssen im linearen Bereich ihrer Kennlinien arbeiten, d.h. sie dürfen nicht übersteuert sein. Erst wenn diese Bedingung erfüllt ist, darf mit der Aufnahme des FID-Signals begonnen werden.

## *Empfangsvorgang*

Der Empfangsvorgang ist ein sehr komplexer Vorgang, bei dem im Wesentlichen drei Probleme auftreten:

1. Das Problem der Strahlungsdämpfung (auf englisch "Radiation Damping"). Diese tritt dann auf, wenn die Spinkonzentration des Lösungsmittels oder der Messsubstanz sehr hoch ist. Die integrierende Wirkung der zahlreichen magnetischen Spins in der Messprobe kann verglichen werden mit einem Resonanzkreis, der stark mit dem HF-Schwingkreis elektromagnetisch gekoppelt ist. In diesem Fall kann der HF-Schwingkreis auf diesen "Resonanzkreis" zurück wirken, was Verbreiterungen, Verzerrungen und Phasenfehler der Spektrallinien zur Folge haben kann.

Bei zwei Schwingkreisen, die in einer bestimmten Entfernung voneinander aufgestellt sind, ist deren elektromagnetische Kopplung, und damit deren gegenseitige Beeinflussung umso größer, je größer die Q-Werte der einzelnen Schwingkreise sind. Bei der Strahlungsdämpfung gibt es ähnliche Verhältnisse, wobei der eine Schwingkreis durch die magnetischen Spins, und der andere durch den HF-Schwingkreis definiert sind. Der erste Schwingkreis besitzt von Natur aus einen sehr hohen effektiven Q-Wert infolge der Eigenschaften der magnetischen Spins. Dieser Q-Wert kann einen Wert von $10^6$-$10^9$ annehmen. Es kommt deshalb bei der Betrachtung der Kopplung in erster Linie auf die Höhe des Q-Wertes des zweiten Schwingkreises, d.h. des HF-Schwingkreises, an. Diese Betrachtungsweise ist äquivalent zur Betrachtung, dass bei einem hohen Q-Wert des HF-Schwingkreises in diesem in Folge der NMR Signale große Ströme fließen, welche die Spins wiederum rückbeeinflussen, je nach Phasenlage des Resonatorstroms. Um die Strahlungsdämpfung möglichst klein zu halten, sollte dieser Q-Wert möglichst niedrig sein, ohne aber das SINO dabei zu verschlechtern.

2. Das nach dem Dämpfungsvorgang stark reduzierte Ausschwingsignal des Resonators als Folge des Sendepulses besitzt immer noch einen Restanteil, der im NMR-Spektrum Verzerrungen der Basislinie verursachen kann. Deshalb ist es wichtig, dass der HF-Schwingkreis auch während des Empfangsvorganges bedämpft wird. Dabei wird die Zeitkonstante des Ausschwingsignals während des Empfangsvorgangs als $\tau_{EV}$ bezeichnet. Der während des Empfangsvorgangs erreichbare Dämpfungswert ist verständlicherweise kleiner (d.h. die Zeitkonstante länger) als der während des Dämpfungsvorganges, denn die Schaltung muss primär auf bestes SINO und nicht auf beste Dämpfung optimiert werden.

3. Die dritte Problematik entsteht dann, wenn der Q-Wert des HF-Schwingkreises während des Empfangsvorganges zu hoch ist, um die ganze Breite des gewünschten NMR-Spektrums zu empfangen. Durch eine gezielte Dämpfung des HF-Schwingkreises während des Empfangsvorganges lässt sich der spektrale Empfangsbereich des HF-Schwingkreises an die Breite des gewünschten NMR-Spektrums anpassen. Eine solche Dämpfung während des Empfangsvorganges macht jedoch nur dann Sinn, wenn während des Sendevorganges der HF-Schwingkreis ebenfalls zusätzlich gedämpft wird, so dass er die gewünschte Anregungsbandbreite erreicht. Letztere sollte größer oder gleich der Breite des gewünschten NMR-Spektrums sein.

Während des Empfangsvorganges ist es wichtig, dass die Dämpfung des HF-Schwingkreises keine Verschlechterung des SINO zur Folge hat, was vorerst als widersprüchlich erscheinen mag, jedoch mit einer so genannten "elektronischen Dämpfung" lösbar ist. Die Dämpfung des HF-Schwingkreises wird durch die elektronische Eingangsimpedanz des Vorverstärkers erreicht [2] - [4]. Der Vorverstärker selber soll jedoch mit seinem Anpassungsnetzwerk rausch-angepasst sein, das heißt der Vorverstärker sieht nach seinem Anpassungsnetzwerk die optimale Quellenimpedanz. (die optimale Quellenimpedanz ist jene Quellenimpedanz, die zum höchsten SINO führt).

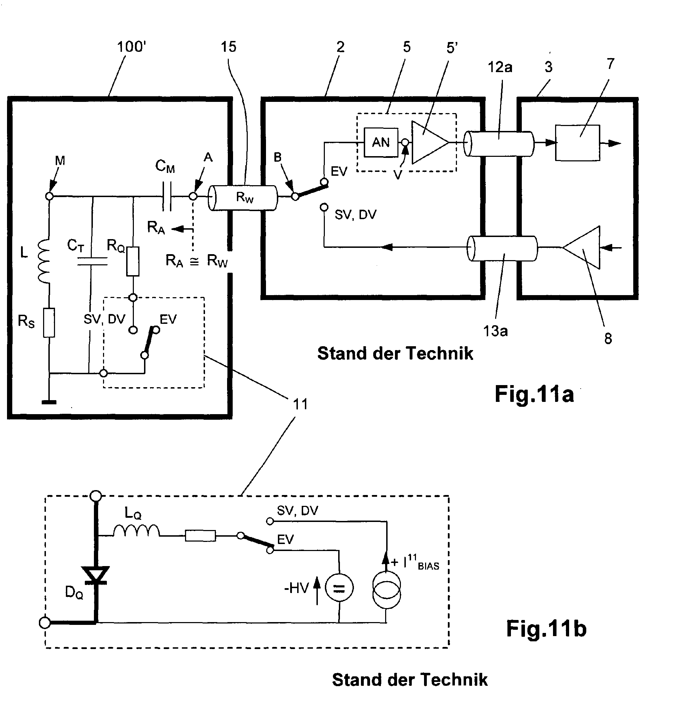

In [1] wird mit Hilfe eines so genannten "Q-Switches" der Q-Wert eines HF-Schwingkreises **100'** während des Sende- und Dämpfungsvorganges klein gehalten (**Fig. 11a, 11b**). Wie der Name bereits sagt, wird dem HF-Schwingkreis 100' mit Hilfe eines Schalters **11** ein Widerstand $R_Q$ hinzugefügt. Widerstand $R_Q$ und Schalter 11 sind in Serie geschaltet und zwischen dem hochohmigen Punkt **M** der Induktivität L des HF-Schwingkreises 100' und Masse angeschlossen. Der Widerstand $R_Q$ dämpft den HF-Schwingkreis 100' und verkleinert dadurch seinen Q-Wert. Der Schalter 11 wird meistens mit einer PIN-Diode $D_Q$ **(Fig. 11b)** realisiert, es sind jedoch auch Schalter mit Feldeffekt-Transistoren (= FET) denkbar. Die PIN-Diode $D_Q$ wird mit einer Hochspannung HV, welche in Sperrrichtung angelegt ist, gesperrt, oder mit einem Strom $I^{11}_{BIAS}$ in Durchlassrichtung in den leitenden Zustand gebracht.

Der Nachteil dieser Anordnung liegt darin, dass die zusätzlichen Komponenten (Widerstand $R_Q$, PIN-Diode $D_Q$, etc.) in der Nähe des empfindlichen HF-Schwingkreises untergebracht werden müssen und dadurch, infolge ihrer magnetischen Suszeptibilität, die Homogenität des statischen Magnetfeldes verschlechtern können. Zusätzlich muss auch ein Steuersignal in den sehr heiklen Bereich des HF-Schwingkreises geführt werden. Die zusätzliche Beschaltung des HF-Schwingkreises führt während des Empfangsvorganges unweigerlich zu einer Reduktion des Q-Wertes und somit zu einem unerwünschten SINO Verlust. Der parallele Verlustwiderstand der PIN-Diode $D_Q$ im gesperrten Zustand genügt nämlich bereits um diesen Verlust zu verursachen.

Darüber hinaus müsste bei kryogen gekühlten HF-Schwingkreisen die PIN-Diode $D_Q$ auch gekühlt werden, was aber wegen des "Carrier-Freeze-Out-Effects" in Halbleitern nur beschränkt möglich und sehr problematisch ist.

Der Q-Switch kann während des Empfangsvorganges nicht direkt zum Dämpfen des HF-Schwingkreises eingesetzt werden, weil dadurch ein viel zu großer Verlust an SINO entstehen würde. Es sind zwar spezielle Verfahren entwickelt worden, bei denen der Q-Switch intermittierend eingesetzt, d.h. im Zeitintervall zwischen zwei Datenpunkten kurzzeitig eingeschaltet und anschließend vor der Erfassung des nächsten Datenpunktes wieder ausgeschaltet wird. Aber auch dieses Verfahren führt zu einem Verlust an SINO und zwar dadurch, dass weniger Zeit für die Datenaufnahme zur Verfügung steht.

Die in [2] verwendete Anordnung besteht aus einem HF-Schwingkreis und einem Vorverstärker, die örtlich eng beisammen liegen und deshalb nicht über eine HF-Leitung miteinander verbunden werden müssen. Der Vorverstärker ist gegengekoppelt und erzeugt dadurch eine Eingangsimpedanz, die von der Größe der Gegenkopplung abhängig ist. Diese Eingangsimpedanz wird während des Empfangsvorganges als Dämpfungsimpedanz für den HF-Schwingkreis benutzt und direkt mit dem hochohmigen Punkt des HF-Schwingkreises verbunden. Da die Dämpfungsimpedanz elektronisch durch aktive Elemente erzeugt wird, nennt man diese Art der Dämpfung auch "elektronische Dämpfung". In der bekannten Schaltung werden zwei getrennte Ankopplungen an den HF-Schwingkreis verwendet: die erste für den Sendevorgang und die zweite für den Dämpfungs- und Empfangsvorgang. Beide Ankopplungen erfolgen am hochohmigen Punkt des HF-Schwingkreises. Während des Sendevorganges wird der HF-Schwingkreis durch die normale Leistungsanpassung gedämpft.

Während der Ausschwingzeit des HF-Schwingkreises (= Dämpfungsvorgang), bleibt dieser praktisch über die ganze Zeit ungedämpft, da aus Sicherheitsgründen die elektronische Dämpfung durch Schutzdioden unwirksam gemacht wird, wie unten erläutert. Erst ganz am Schluss der Ausschwingzeit wird die elektronische Dämpfung wieder wirksam, kann aber dann keine signifikante Reduktion der Gesamtzeit des Ausschwingvorganges mehr bewirken.

Während des Empfangsvorganges wird eine optimale Rauschanpassung des Vorverstärkers erreicht. Wenn der Quotient vom Betrag der Eingangsimpedanz und vom Betrag der optimalen Quellenimpedanz des Vorverstärkers sehr verschieden von 1 ist, kann zudem auch eine Dämpfung des HF-Schwingkreises ohne Verlust an SINO erreicht werden. Durch die beiden Anpassungspfade an den HF- Schwingkreis während des Sende- und Empfangsvorganges wird dieser jedoch zusätzlich belastet, was schlussendlich trotzdem zu einem Verlust an SINO führt, vor allem bei sehr hohen Q-Werten des HF- Schwingkreises.

Heutige Vorverstärker benötigen normalerweise am Eingang Schutzdioden, die gegen Überspannungen während des Sendevorganges schützen sollen. Diese wirken mehr oder weniger wie niederohmige Spannungsquellen von ca. 2 V und verhindern dadurch während des Sendepulses und dem anschließenden Ausschwingvorgang des HF-Schwingkreises das Auftreten von zu hohen Spannungen am empfindlichen Eingang des Vorverstärkers. Das hat zur Folge, dass die elektronische Dämpfung durch die Eingangsimpedanz des Vorverstärkers erst dann wirksam wird und seine dämpfende Wirkung ausüben kann, wenn der Vorverstärker mit seinen Schutzdioden im linearen Bereich arbeitet. Der Hauptanteil des Ausschwingvorganges erfährt somit in der vorliegenden Anordnung, die nur mit einer elektronischen Impedanz als Dämpfungsmittel arbeitet, keine zusätzliche Dämpfung und die Spule schwingt aus, mit der unbedämpften Zeitkonstante.

Außerdem ist bei heutigen NMR-Spektrometern mit supraleitenden Hochfeldmagneten die enge räumliche Anordnung von HF-Schwingkreis und Vorverstärker praktisch nicht möglich, da in unmittelbarer Nähe des HF-Schwingkreises kein Platz für den Vorverstärker vorhanden ist. Zudem ist dort die magnetische Feldstärke des NMR-Magneten zu hoch für eine unproblematische Funktionsweise des Vorverstärkers, und des weiteren benötigen kryogen gekühlte HF-Schwingkreise und Vorverstärker jeweils unterschiedliche kryogene Temperaturen, wenn sie optimal betrieben werden sollen, d.h. beide Einheiten müssten thermisch voneinander isoliert werden, und das wäre wiederum aus Platzgründen sehr problematisch.

Dazu kommt noch, dass die weiter oben beschriebene Gegenkopplung des Vorverstärkers bei den heutigen Hochfeldsystemen aus Gründen der Stabilität praktisch nicht realisierbar ist. Die dort herrschenden hohen NMR-Frequenzen haben z.B. bei einem 900 MHz NMR-Spektrometer zur Folge, dass eine Gegenkopplung des Vorverstärkers zu starken Schwingneigungen führt, die nur mit einem immensen Aufwand oder gar nicht zu beheben sind.

Aus all diesen Gründen, ist die aus [2] bekannte Anordnung für heutige Hochfeld-NMR-Spektrometer ungeeignet.

Aus [3] ist eine Anordnung bekannt, die einem HF-Schwingkreis und einen Vorverstärker umfasst, die beide ebenfalls örtlich nahe beisammen liegen. Die Möglichkeit einer örtlichen Trennung der beiden Objekte und deren Verbindung über eine HF-Leitung werden zwar erwähnt, ohne jedoch auf die dabei auftretende Problematik (Behandlung der optimalen Bedämpfung unter der Einschränkung, die sich durch die Anpassung an die Leitung mit der Impedanz $R_W$ ergibt) einzugehen. Wie bei der Anordnung aus [2] wird auch in die Anordnung aus [3] eine elektronische Dämpfung des HF-Schwingkreises mit Hilfe der Eingangsimpedanz des aktiven Teils des Vorverstärkers (ohne Anpassungsnetzwerk) erreicht, wobei diese Dämpfung keinen Verlust des optimalen SINO verursacht und umso stärker ist, je mehr sich der Wert des Betrages der Eingangsimpedanz dividiert durch den Betrag des optimalen Rauschwiderstandes des Vorverstärkers von 1 unterscheidet (overcoupling). Die Ankopplung an den HF-Schwingkreis erfolgt am niederohmigen Punkt A des HF-Schwingkreises. Es werden verschiedene Arten der Impedanztransformation zwischen dem Punkt A und dem hochohmigen Punkt M des HF-Schwingkreises vorgeschlagen und bezüglich SINO untersucht.

Mit der Anordnung aus [3] wird eine Reduktion der Ausschwingzeit um 30 % erreicht. Dies ist jedoch für ein heutiges Hochfeldsystem viel zu wenig. Vielmehr sind Reduktionen um ca. 90 % erstrebenswert. Ferner treten bei großem "overcoupling" ungewünschte Effekte auf, z.B. Sättigungseffekte im Vorverstärker wodurch die Ausschwingzeiten wieder zunehmen können. Es kann sogar vorkommen, dass der Ausschwingvorgang zwei Frequenzkomponenten enthält und die Umhüllende sehr langsam abklingt.

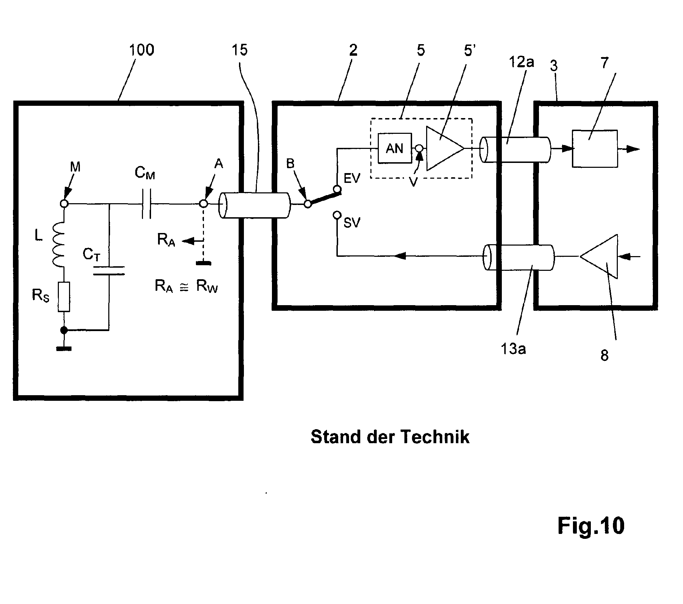

Die aus [4] bekannte Anordnung umfasst ebenfalls einen HF-Schwingkreis **100** und ein Vorverstärker-Modul **2,** die jedoch beide örtlich entfernt voneinander aufgestellt und durch eine HF-Leitung **15** miteinander verbunden sind **(Fig. 10)**. Der HF-Schwingkreis **100** umfasst eine Induktivität L und einen Verlustwiderstand $R_S$ und ist an einem niederohmigen Anschlusspunkt **A** über die HF-Leitung **15** der Leitungsimpedanz $R_W$ mit einem Vorverstärker-Modul **2** verbunden, welches einen Vorverstärker **5** mit einem Anpassungsnetzwerk **AN** sowie mit dem aktiven Teil **5'** des Vorverstärkers umfasst.

Damit das SINO erhalten bleibt, muss die Impedanztransformation des Verlustwiderstandes $R_s$ der Induktivität L des HF-Schwingkreises 100 bezogen auf einen Punkt V zwischen dem Anpassungsnetzwerk AN und dem Eingang des aktiven Teils 5' des Vorverstärkers 5 einen Impedanzwert ergeben, der gleich der optimalen Quellenimpedanz des aktiven Teils des Vorverstärkers 5' ist. Wenn diese Bedingung erfüllt ist, und wenn das Verhältnis der Beträge der optimalen Quellenimpedanz zur Eingangsimpedanz des aktiven Teils des Vorverstärkers 5' sehr verschieden von 1 ist, dann ist die Transformierte der Eingangsimpedanz des Vorverstärkers 5 bezogen auf den niederohmigen Anschlusspunkt A des HF-Schwingkreises 100 sehr verschieden von der Leitungsimpedanz $R_W$ der HF-Leitung 15 zwischen dem HF-Schwingkreis 100 und dem Vorverstärker-Modul 2 und erlaubt dadurch eine viel stärkere Dämpfung des HF-Schwingkreises 100 im Vergleich zu einer gewöhnlichen Leistungsanpassung.

Man führt die Impedanztransformation zwischen dem HF-Schwingkreis 100 und dem Vorverstärker 5 so aus, dass in einem ersten Schritt der Verlustwiderstand $R_S$ der Induktivität L des HF-Schwingkreises 100 mit Hilfe eines Koppelkondensators **$C_M$** auf einen Wert **$R_A$** am niederohmigen Anschlusspunkt A transformiert wird. Dabei wird üblicherweise $R_A=R_W$ gewählt. Somit erreicht man, dass die HF-Leitung 15, die den Wellenwiderstand $R_W$ besitzt, am niederohmigen Anschlusspunkt A reflexionsfrei angepasst ist, so dass weniger Verluste in der HF-Leitung entstehen.

Vom Punkt **B** aus, der am vom HF-Schwingkreis abgewandten Ende der HF-Leitung 15 angeordnet ist, in die HF-Leitung 15 gesehen erscheint somit der Widerstandswert $R_W$. Dieser wird in einem zweiten Schritt mit Hilfe des Anpassungsnetzwerkes AN so transformiert, dass der aktive Teil des Vorverstärkers 5' die optimale Quellenimpedanz am Punkt V sieht.

In [4] werden also weitgehende Maßnahmen zur Reduktion der Strahlungsdämpfung während des Empfangsvorganges beschrieben. Diese Maßnahmen können zugleich auch eine starke dämpfende Wirkung auf den HF-Schwingkreis während des Empfangsvorganges ausüben, ohne dass dabei ein Verlust an SINO entsteht. Die Ankopplung an den HF-Schwingkreis erfolgt am niederohmigen Anschlusspunkt A des HF-Schwingkreises. Auf die bestmögliche Bedämpfung des HF-Schwingkreises während des Empfangsvorganges und auf die dabei entstehenden Vorteile für das Ausschwingen des HF Schwingkreises wird jedoch nicht eingegangen.

Der Q-Wert des HF-Schwingkreises spielt eine zentrale Rolle beim Entwurf eines Sende/Empfangssystems für die NMR, und es besteht deshalb großes Bedürfnis nach einer Methode, um die störenden Einflüsse des hohen Q-Wertes des HF-Schwingkreises während des Sende-, Dämpfungs- und Empfangsvorganges möglichst stark zu reduzieren, wobei während des Empfangsvorganges kein Verlust an SINO entstehen darf.

Der beschriebene Stand der Technik sieht, wenn der Dämpfungsvorgang betrachtet wird, und wenn die Dämpfung am niederohmigen Punkt A des HF-Schwingkreises erfolgt, ausschließlich Lösungen mit elektronischen Dämpfungsimpedanzen (= Eingangsimpedanzen von Vorverstärkern) vor, die infolge ihrer nichtlinearen Eigenschaften keine optimale Dämpfung des HF-Schwingkreises erlauben, da insbesondere die Dämpfung erst wirkt, wenn die Amplitude der Schwingung so klein geworden ist, dass sie im linearen Bereich des Vorverstärkers ist. Dazu muss sie aber bereits schon weitgehend abgeklungen sein. Somit verstreicht die meiste Zeit ungedämpft.

Die bekannten Lösungsvorschläge stellen lediglich einzelne Insellösungen dar, die entweder für den Sende- und Dämpfungs- oder für den Empfangsvorgang optimiert sind, nicht jedoch eine umfassende Lösung, die optimale Verhältnisse bei allen drei Vorgängen schafft.

Es ist daher Aufgabe der Erfindung eine MR-Detektionsanordnung, bei der der HF-Schwingkreis und das Vorverstärker-Modul örtlich voneinander getrennt sind, mit einem umfassenden Dämpfungskonzept vorzustellen, bei dem alle drei Vorgänge (Sende-, Dämpfungs- und Empfangsvorgang) optimiert sind.

Diese Aufgabe wird erfindungsgemäß dadurch gelöst, dass im Vorverstärker-Modul mindestens eine, der HF-Leitung nachfolgende passive Dämpfungsimpedanz vorgesehen ist, wobei die passive Dämpfungsimpedanz während eines Dämpfungs- und/oder Sendevorgangs, bei dem von einem HF-Sender HF-Pulse zur Anregung eines Spinsystems an den HF-Schwingkreis gesendet werden, mittels einer Schalteinrichtung zu dem Schwingkreis zuschaltbar ist, und wobei der jeweilige Betrag des komplexen Reflexionsfaktors der passiven Dämpfungsimpedanz bezogen auf die Wellenwiderstand der HF-Leitung den Wert von 0.5 übersteigt.

Unter einer passiven Dämpfungsimpedanz wird eine Impedanz verstanden, die durch ein oder mehrere passive Bauelemente beziehungsweise eine passive Schaltung realisiert wird.

Die passiven Dämpfungsimpedanzen sind Teile eines Dämpfungspfads beziehungsweise eines Sendepfads, wobei der Sendepfad während des Sendevorganges die Schalteinrichtung mit dem HF-Sender, und während des Dämpfungsvorganges der Dämpfungspfad die Schalteinrichtung mit einer Dämpfungsimpedanz verbindet. Darüber hinaus ist ein Empfangspfad vorgesehen, der die Schalteinrichtung während des Empfangsvorganges mit dem Vorverstärker verbindet. Durch die Schalteinrichtung der erfindungsgemäßen Vorrichtung ist der HF-Schwingkreis wahlweise mit dem Dämpfungspfad und der dazugehörigen Dämpfungsimpedanz, mit dem Sendepfad und der dazugehörigen Dämpfungsimpedanz oder einem Empfangspfad verbindbar.

Der durch eine Impedanztransformation erzeugte niederohmige Anschlusspunkt des Schwingkreises, der zugleich das eine Ende der HF-Leitung darstellt, welches mit dem HF-Schwingkreis verbunden ist, weist zwei wichtige Merkmale auf:

1. Vom niederohmigen Anschlusspunkt in den HF-Schwingkreis gesehen erscheint ungefähr der Wellenwiderstand der HF-Leitung, so dass die HF-Leitung am niederohmigen Anschlusspunkt quasi reflexionsfrei abgeschlossen ist.

2. Der niederohmige Anschlusspunkt dient als Anschlusspunkt für die Dämpfungsimpedanz oder deren Transformierte.

Da beim erfinderischen Dämpfungskonzept durchwegs der niederohmige Anschlusspunkt zur Dämpfung des HF-Schwingkreises verwendet wird, eignet sich dieses Dämpfungskonzept insbesondere, wenn die Dämpfungsimpedanzen mit Hilfe der HF-Leitung örtlich getrennt vom HF-Schwingkreis positioniert sowie ein- oder ausgeschaltet werden sollen, wodurch die empfindliche Umgebung des HF-Schwingkreises ungestört bleibt.

Während des Empfangsvorganges wird in erster Linie eine optimale Rauschanpassung des Vorverstärkers angestrebt, damit ein möglichst hohes SINO resultiert. Zudem sollte die Transformierte der Eingangsimpedanz des Vorverstärkers am niederohmigen Anschlusspunkt, möglichst nahe an dem optimalen Dämpfungswiderstand sein, um eine möglichst große Dämpfung des HF-Schwingkreises ohne Verlust an SINO zu erreichen. Ein Ausschwingsignal während des Empfangsvorgangs führt zu breiten, künstlichen Spektrallinien. Das Signal klingt mit der Zeitkonstante $\tau_{EV}$ während dem Empfangsvorgangs ab, welche möglichst kurz sein sollte, damit das residuale Signal möglichst klein ist. Die für die maximale Dämpfung, die zu erreichen ist, benötigte Phasenlage der am niederohmigen Anschlusspunkt erscheinenden Transformierten der Vorverstärker-Eingangsimpedanz lässt sich durch Wahl der Länge der HF-Leitung realisieren.

Während des Dämpfungsvorgangs kann eine maximale Dämpfung des HF-Schwingkreises mit Hilfe der Dämpfungsimpedanz des Dämpfungsvorgangs realisiert werden. Dazu muss die am niederohmigen Anschlusspunkt transformierte Dämpfungsimpedanz des Dämpfungsvorgangs ungefähr gleich dem optimalen Dämpfungswiderstand $(R_D)_{OPT}$ sein. $(R_D)_{OPT}$ ist unter allen möglichen Widerstandswerten der, welcher zu einer optimal hohen Dämpfung des HF-Schwingkreises führt und kann für die jeweilige Anordnung berechnet werden. Dabei ist der optimale Dämpfungswiderstand in erster Ordnung abhängig von der Frequenz ω und der Matchingimpedanz $M_k$ bez. $X_c$

Während des Sendevorganges kann ebenfalls eine maximale Dämpfung des HF-Schwingkreises mit Hilfe der Dämpfungsimpedanz des Sendevorgangs realisiert werden. Dabei soll die Transformierte von der Dämpfungsimpedanz an niederohmigen Anschlusspunkt, falls mit den Leistungsanforderungen vereinbar, an der optimalen Impedanz zu liegen kommen. Ist dies der Fall, dann sind die Dämpfungszustände sowohl beim Dämpfungs- wie auch beim Sendevorgang gleich, und man kommt mit einer einzigen Dämpfungsimpedanz aus, nämlich mit der Dämpfungsimpedanz des Sendevorganges. Diese muss nun aber so geschaltet sein, dass sie auch beim Dämpfungsvorgang wirksam ist. Falls nicht möglich, so kann die maximale mit den Leistungsanforderungen vereinbare Dämpfung durch eine schwächere Transformation im Dämpfungsnetzwerk (d.h. bei der die Impedanz des zur HF Spule führenden Anschlusses des betreffenden Dämpfungsnetzwerks näher bei $R_W$ liegt) erreicht werden

Während der oben beschriebene Stand der Technik, wenn der Sendevorgang betrachtet wird, und wenn die Dämpfung am niederohmigen Anschlusspunkt des HF-Schwingkreises erfolgt, nur die automatisch vorhandene Dämpfung infolge der Leistungsanpassung beinhaltet, sieht die vorliegende Erfindung zusätzliche passive Dämpfungsimpedanzen vor, um für jeden Vorgang (Sendevorgang, Dämpfungsvorgang, Empfangsvorgang) eine passende Dämpfungsimpedanz zur Verfügung zu stellen, um dadurch eine verbesserte Dämpfung zu erreichen. Dies ist ohne Beeinträchtigung der Leistung des Systems möglich, da heutige Leistungssender für die NMR genügend Leistung besitzen, um nicht nur den HF-Schwingkreis optimal zu bedienen, sondern um auch die Verlustleistung dieser zusätzlichen passiven Dämpfungsimpedanz zu decken.

Mit der erfindungsgemäßen MR-Detektionsanordnung kann eine erhebliche Reduktion der Zeitkonstante erreicht werden.

Vorzugsweise dient der HF-Schwingkreis zur Anregung des Spinsystems während des Sendevorgangs und zur Detektion von FID-Signalen während eines Empfangsvorgangs, wobei die Schalteinrichtung den HF-Schwingkreis während des Empfangsvorgangs mit dem HF-Empfänger und während des Sendevorgangs mit dem HF-Sender verbindet. Die Verbindung des HF-Schwingkreises mit dem HF-Empfänger erfolgt über den Empfangspfad, die Verbindung des HF-Schwingkreises mit dem HF-Sender über den Sendepfad.

Bei einer solchen Ausführungsform ist es vorteilhaft, wenn die Schalteinrichtung einen dreiphasigen HF-Schalter, d.h. einen Schalter mit drei Schaltpositionen umfasst.

Alternativ dazu kann der HF-Schwingkreis nur zur Detektion von FID-Signalen während des Empfangsvorganges dienen und kann während des Dämpfungsvorganges mit der passiven Dämpfungsimpedanz bedämpft werden, wobei für die Anregung des Spinsystems während des Sendevorganges ein HF-Sendeschwingkreis vorgesehen ist, der vorzugsweise räumlich orthogonal zum HF-Schwingkreis angeordnet ist, wobei mindestens eine weitere passive Dämpfungsimpedanz während des Sende- und/oder Dämpfungsvorganges mit dem HF-Sendeschwingkreis verbunden ist, so dass der HF-Sendeschwingkreis mit der weiteren passiven Dämpfungsimpedanz bedämpft werden kann.

Bei einer vorteilhaften Ausführungsform der erfindungsgemäßen MR-Detektionsanordnung ist zumindest eine der passiven Dämpfungsimpedanzen so gewählt, dass am niederohmigen Anschlusspunkt A in Richtung der HF-Leitung gesehen, eine optimale Impedanz $(R_D)_{OPT}$ vorliegt, wobei bei einer induktiven Transformationsschaltung, bei der der Blindanteil der Koppelinduktivität kapazitiv mit einem Kondensator kompensiert wird, $(R_D)_{opt}=\omega*M_k$ in guter Näherung gilt, wobei $M_k$ der Gegeninduktivität der induktiven Ankopplung der Transformationsschaltung entspricht.

Die optimale Impedanz verursacht die maximale Dämpfung, und somit das schnellste Ausschwingen des HF-Schwingkreises. Unter der maximalen Dämpfung ist zu verstehen, dass die Umhüllende des Stroms im Schwingkreis schnellstmöglich nachhaltig abklingt. Die im HF Schwingkreis vorhandene Energie wird dabei vernichtet, also in Wärme umgesetzt, so dass ein Pendeln der Energie zwischen dem HF Schwingkreis und einem anderen resonanten Gebilde vermieden wird. Die Abweichung der Werte der Impedanzen von der optimalen

Impedanz darf bis zu ± 30% sein, ohne dass eine wesentliche Verlängerung des Ausschwingens stattfindet (ca. 10% größere Zeitkonstante).

Bei einer alternativen Ausführungsform ist zumindest eine der Dämpfungsimpedanzen (so gewählt, dass am niederohmigen Anschlusspunkt in Richtung der HF-Leitung gesehen, eine optimale Impedanz $(R_D)_{OPT}$ vorliegt, wobei die reaktive Transformationsschaltung einen kapazitiven Blindwiderstand $X_S$ umfasst, der als Impedanztransformator wirkt, wobei die optimale Impedanz $(R_D)_{OPT}$ durch den Wert des Blindwiderstandes $X_S$ bestimmt wird, und wobei in guter Näherung gilt $(R_D)_{OPT} = X_S$.

Der Blindwiderstand ist hierbei zwischen dem hochohmigen Punkt und dem niederohmigen Anschlusspunkt des HF-Schwingkreises als Impedanztransformator angeordnet.

Eine besonders vorteilhafte Ausführungsform der Erfindung sieht ein Dämpfungsnetzwerk zur Erzeugung der zuschaltbaren passiven Dämpfungsimpedanz vor, wobei das Dämpfungsnetzwerk einen Anschluss zu dem HF-Sender aufweist, und dabei zur HF-Leitung fehlangepasst, zum HF-Sender jedoch angepasst ist.

Der HF-Schwingkreis wird während des Sendevorganges zusätzlich gedämpft, um seine Frequenz-Bandbreite auf den erforderlichen Wert zu vergrößern. Hierdurch kann während des Sendevorgangs die Anstiegszeit des Stroms in der Induktivität des HF-Schwingkreises reduziert werden.

Eine weitere vorteilhafte Ausführungsform sieht einen steuerbarer HF-Widerstand, insbesondere eine PIN-Diode, zur Erzeugung der passiven Dämpfungsimpedanz vor. Mit Hilfe des HF-Widerstands lässt sich die Dämpfung des HF-Schwing-kreises während des Dämpfungsvorganges definieren, so dass vorzugsweise die optimale Impedanz am niederohmigen Anschlusspunkt erzeugt wird.

Die Erfindung betrifft auch ein Verfahren zur Dämpfung eines HF-Schwingkreises einer zuvor beschriebenen MR-Detektionsanordnung, wobei während des Dämpfungs- und/oder des Sendevorganges eine Dämpfung des HF-Schwingkreises mit einer Zeitkonstantenreduktion größer als ein Faktor 2 erfolgt gegenüber einem Abschluss mit dem Wellenwiderstand der HF-Leitung am niederohmigen Anschlusspunkt, indem mittels der Schalteinrichtung die passive Dämpfungsimpedanz zu dem Schwingkreis zugeschaltet wird.

Vorzugsweise erfolgen die Anregung des Spinsystems während des Sendevorganges und die Detektion des FID-Signals während des Empfangsvorganges mittels desselben HF-Schwingkreises.

Alternativ dazu ist es auch möglich, dass die Detektion des FID-Signals während des Empfangsvorganges mittels des HF-Schwingkreises und die Anregung des Spinsystems während des Sendevorganges mittels des HF-Sendeschwingkreises erfolgen.

Eine vorteilhafte Variante des erfindungsgemäßen Verfahrens sieht vor, dass während des Sende- und/ oder Dämpfungsvorgangs über die HF-Übertragungsleitung hinzu geschaltete passive Dämpfungsimpedanz mittels des Dämpfungsnetzwerks erzeugt wird, welches am HF-Sender angeschlossen ist und zur Leitung fehlangepasst, zum Sender jedoch angepasst wird.

Darüber hinaus ist es vorteilhaft, wenn die optimale Impedanz mittels des steuerbaren HF-Widerstandes und der nachfolgenden Transformation am niederohmigen Anschlusspunkt erzeugt wird.

Die erfindungsgemäße MR-Detektionsanordnung und das zugehörige Verfahren realisieren eine optimale Dämpfung des HF-Schwingkreises sowohl beim Sende-, beim Dämpfungs- als auch beim Empfangsvorgang, wobei als optimale Dämpfung die Dämpfung bezeichnet wird, bei welcher die transformierte Dämpfungsimpedanz bezogen auf den niederohmigen Anschlusspunkt jenen Wert unter allen möglichen Werten annimmt, der zu einer maximalen Dämpfung des HF-Schwingkreises führt.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:

Fig. 1          ein Prinzipschaltbild einer Ausführungsform der erfindungsgemäßen MR-Detektionsanordnung mit Dämpfungsvorrichtungen für den HF-Schwingkreis, die während des Sende- und Dämpfungsvorganges aktiviert oder deaktiviert werden;

Fig. 2          ein Prinzipschaltbild einer alternativen Ausführungsform der erfindungsgemäßen MR-Detektionsanordnung mit einem separaten HF-Sendeschwingkreis für die Anregung des Spinsystems;

Fig. 3          ein detailliertes Schaltbild einer Ausführungsform der erfindungsgemäßen MR-Detektionsanordnung mit kapazitiver Ankopplung des HF-Schwingkreises und mit einer optimalen Dämpfung des HF-Schwingkreises während des Dämpfungsvorganges mit Hilfe des HF-Widerstandes einer Diode;

Fig. 4          ein detailliertes Schaltbild einer weiteren Ausführungsform der erfindungsgemäßen MR-Detektionsanordnung mit einem induktiven Impedanztransformator für die Ankopplung des HF-Schwingkreises und mit einer optimalen Dämpfung des HF-Schwingkreises während des Dämpfungsvorganges mit Hilfe des HF-Widerstandes einer Diode;

Fig. 5          ein detailliertes Schaltbild einer weiteren Ausführungsform der erfindungsgemäßen MR-Detektionsanordnung, bei der die Möglichkeit besteht, den HF-Schwingkreis während des Sendevorgangs durch eine Widerstandsgruppe und während des Dämpfungsvorgangs durch den HF-Widerstand einer Diode optimal zu bedämpfen;

Fig. 6          ein detailliertes Schaltbild einer weiteren Ausführungsform der erfindungsgemäßen MR-Detektionsanordnung, bei der die Möglichkeit besteht, den HF-Schwingkreis während des Sendevorgangs durch ein Widerstands-Transformatornetzwerk und während des Dämpfungs-vorgangs durch den HF-Widerstand der Diode optimal zu bedämpfen.

Fig. 7a          den zeitlichen Verlauf eines Sendepulses der Schaltung von Fig. 3 oder Fig. 4, der in den HF-Schwingkreis eingespeist wird;

Fig. 7b     den zeitlichen Verlauf des Stroms in der Induktivität des HF-Schwingkreises der Schaltung von Fig. 3 oder Fig. 4;

Fig. 7c     den zeitlichen Verlauf des FID-Signals (= Kernresonanzsignal) der Schaltung von Fig. 3 oder Fig. 4;

Fig. 7d     den zeitlichen Verlauf des Stroms und der Spannung zur Steuerung von Sendedioden der Schaltung von Fig. 3 oder Fig. 4;

Fig. 7e     den zeitlichen Verlauf des Stroms zur Steuerung der Diode D3 der Schaltung von Fig. 3 oder Fig. 4;

Fig. 8a     den zeitlichen Verlauf eines Sendepulses, der in den HF-Schwingkreis einer ersten Ausführungsform der Schaltung von Fig. 5 oder Fig. 6 eingespeist wird;

Fig. 8b     den zeitlichen Verlauf des Stroms in der Induktivität des HF-Schwingkreises einer ersten Ausführungsform der Schaltung von Fig. 5 oder Fig. 6;

Fig. 8c     den zeitlichen Verlauf des FID-Signals (= Kernresonanzsignal) einer ersten Ausführungsform der Schaltung von Fig. 5 oder Fig. 6;

Fig. 8d     den zeitlichen Verlauf des Stroms und der Spannung zur Steuerung von Sendedioden einer ersten Ausführungsform der Schaltung von Fig. 5 oder Fig. 6;

Fig. 8e     den zeitlichen Verlauf des Stroms zur Steuerung der Diode D3 einer ersten Ausführungsform der Schaltung von Fig. 5 oder Fig. 6;

Fig. 9a     den zeitlichen Verlauf eines Sendepulses, der in den HF-Schwingkreis einer zweiten Ausführungsform der Schaltung von Fig. 5 oder Fig. 6 eingespeist wird;

Fig. 9b     den zeitlichen Verlauf des Stroms in der Induktivität des HF-Schwingkreises einer zweiten Ausführungsform der Schaltung von Fig. 5 oder Fig. 6;

Fig. 9c     den zeitlichen Verlauf des FID-Signals (= Kernresonanzsignal) einer zweiten Ausführungsform der Schaltung von Fig. 5 oder Fig. 6;

Fig. 9d     den zeitlichen Verlauf des Stroms und der Spannung zur Steuerung von Sendedioden einer zweiten Ausführungsform der Schaltung von Fig. 5 oder Fig. 6;

Fig. 9e     den zeitlichen Verlauf des Stroms zur Steuerung der Diode D3 einer zweiten Ausführungsform der Schaltung von Fig. 5 oder Fig. 6;

Fig. 10     eine Sende/Empfangs-Vorrichtung gemäß dem Stand der Technik, bei dem während des Empfangsvorganges der HF-Schwingkreis an seinem niederohmigen Anschlusspunkt bedämpft wird;

Fig. 11a     eine Sende/Empfangs-Vorrichtung gemäß dem Stand der Technik, bei dem während des Dämpfungsvorganges der HF-Schwingkreis mit Hilfe eines Q-Switches bedämpft wird; und

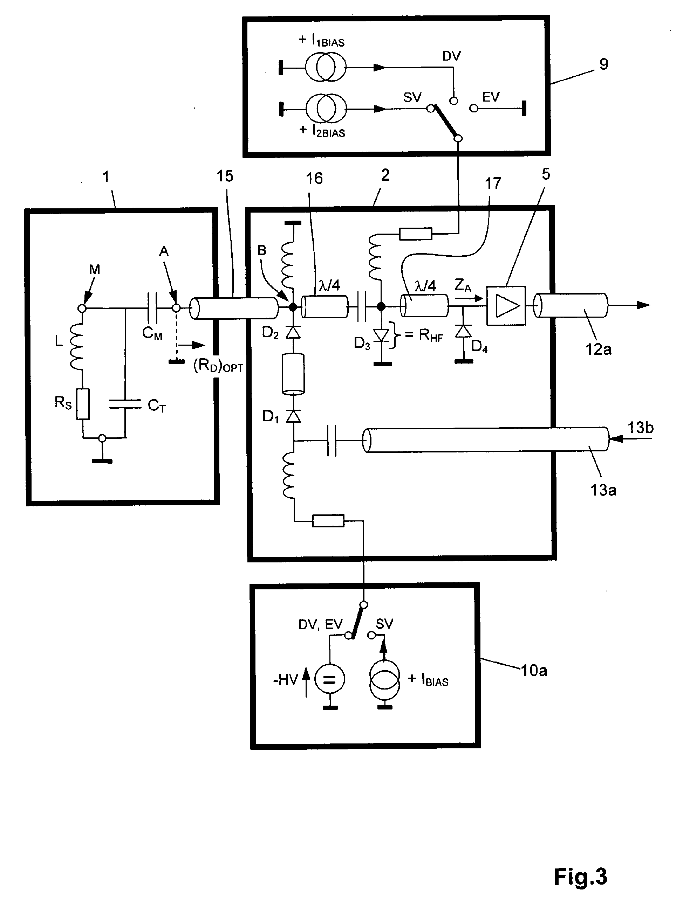

Fig. 11 b     eine Realisierung des Q-Switches aus Fig. 3 mit Hilfe einer Diode.

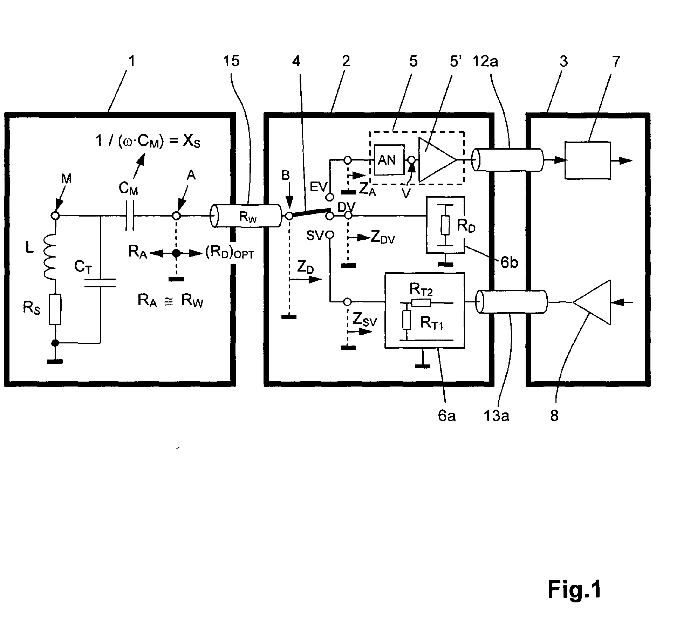

Die erfindungsgemäße Vorrichtung ist in Fig. 1 schematisch dargestellt. Sie wurde in drei Hauptblöcke unterteilt, nämlich einen HF-Schwingkreis 1, welcher sich auf einer sehr tiefen Temperatur (z.B. 20K oder tiefer) befinden kann, ein Vorverstärker-Modul 2, dessen Temperatur sich z.B. auf 77K befindet, und ein Sender/ Empfänger-Modul 3 mit einem HF-Sender 8 und einem HF-Empfänger 7, welches üblicherweise in einer Spektrometerkonsole untergebracht ist. Das Vorverstärker-Modul 2 umfasst einen Empfangspfad mit einem rauscharmen Vorverstärker 5 umfassend ein Anpassungsnetzwerk AN und einen aktiven Vorverstärker **5'**, einen Sendepfad mit einem Dämpfungsnetzwerk **6a** für einen Sendevorgang **SV** mit Dämpfungswiderständen $R_{T1}$, $R_{T2}$, und einen Dämpfungspfad mit einem Dämpfungsnetzwerk 6b für einen Dämpfungsvorgang DV mit einem Dämpfungswiderstand $R_D$, sowie eine Schalteinrichtung in Form eines HF-Schalters **4,** mit dem der Sendevorgang SV, Dämpfungsvorgang DV und Empfangsvorgang EV eingeleitet werden können, indem eine Verbindung zwischen dem HF-Schwingkreis 1 und dem Sendepfad, Dämpfungspfad beziehungsweise Empfangspfad hergestellt wird. Die Dämpfungsnetzwerke 6a, 6b erzeugen Dämpfungsimpedanzen $Z_{SV}$, $Z_{DV}$ zur Dämpfung des HF-Schwingkreises 1.

Zwischen den drei Hauptblöcken werden die Hochfrequenzsignale über eine HF-Leitung **15** mit einem Wellenwiderstand $R_W$, eine HF-Ausgangsleitung **12a,** und eine HF-Eingangsleitung **13a** übertragen, die vorzugsweise als Koaxialkabel mit geringer thermischer Leitfähigkeit ausgebildet sind. Dabei ist ein niederohmiger Anschlusspunkt A des HF-Schwingkreises 1 über die HF-Leitung 15 mit dem Vorverstärker-Modul 2, verbunden.

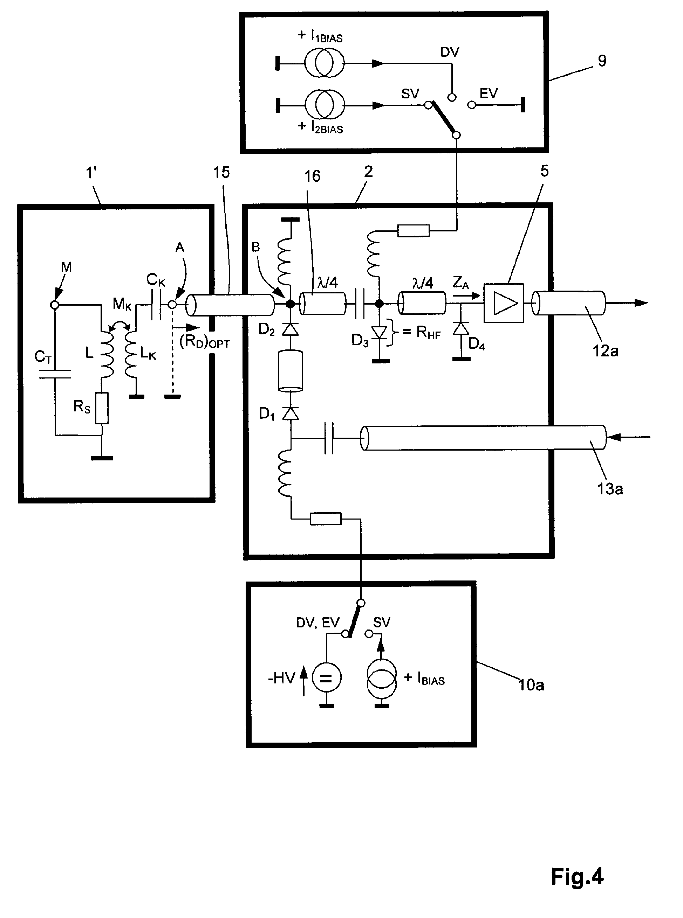

Der HF-Schwingkreis 1 aus Fig. 1 ist als Parallelschwingkreis mit kapazitiver Ankopplung ausgeführt, wobei eine Induktivität **L** mit einem Verlustwiderstand $R_S$ parallel zu einer Resonanzkapazität $C_T$ geschaltet ist. Denkbar sind jedoch auch andere Schwingkreis-Topologien mit kapazitiver und/oder induktiver Ankopplung (Fig. 4).

Bei der in Fig. 1 gezeigten Ausführungsform der erfindungsgemäßen MR-Detektionsanordnung kann das Vorverstärker-Modul 2 mit Hilfe eines Schalters, nämlich des HF Schalters 4, in drei verschiedene Zustände (Sendevorgang SV, Dämpfungsvorgang DV und Empfangsvorgang EV) geschalten werden. Somit kann der HF-Schwingkreis 1 während des Sendevorgangs SV mit der passiven Dämpfungsimpedanz $Z_{SV}$, und während des Dämpfungsvorgangs DV mit der passiven Dämpfungsimpedanz $Z_{DV}$ bedämpft werden. Während des Sendevorgangs SV wird der HF-Verstärker (Leistungsverstärker) 8 zum HF-Schwingkreis 1 durchgeschaltet. In der kurzen Zeit zwischen Senden und Empfang, wird der HF-Schwingkreis 1 mit dem Dämpfungswiderstand $R_D$ verbunden (Dämpfungsvorgang DV), so dass der Strom im HF-Schwingkreis 1 schnell ausklingt. Wie nachfolgend noch gezeigt wird, ist die Dimensionierung dieses Dämpfungswiderstandes $R_D$ äußerst kritisch, kann jedoch optimiert werden. Anschließend wird der HF-Schwingkreis 1 mit dem rauscharmen Vorverstärker 5 (LNA = Low Noise Amplifier) verbunden (Empfangsvorgang EV). Die komplexe Eingangsimpedanz $\mathbf{Z_A}$ des LNAs 5 zusammen mit der Länge der HF-Leitung 15 wird so gewählt, dass wiederum die noch im HF-Schwingkreis 1 durch den Senderpuls vorhandene Energie bestmöglich abgeführt wird, primär wird die Schaltung jedoch für ein optimales, also ein hohes SINO dimensioniert (Rauschanpassung).

Bei der erfindungsgemäßen MR-Detektionsanordnung sind der HF-Schwingkreis 1 und das Vorverstärker-Modul 2 örtlich voneinander getrennt und mittels der HF-Leitung 15 miteinander verbunden. Der HF-Schalter 4 der in Fig. 1 gezeigten Ausführungsform ist dreiphasig ausgeführt, d.h. der Schalter umfasst drei Stellungen beziehungsweise Schaltmöglichkeiten. Dieser, sowie der impedanzkontrollierte und rauschangepasste LNA 5 erlauben ein schnelles Ausklingen des HF-Schwingkreises 1 nach Anwenden eines Senderpulses.

Die erfindungsgemäße Vorrichtung erlaubt es, kryogen gekühlte HF-Schwingkreise 1 mit höchsten Güten (z.B. aus Hochtemperatursupraleiter = HTSC) in heutigen Hochfeldsystemen einzusetzen, ohne die beschriebenen Probleme, verursacht durch das Ausschwingen, hinnehmen zu müssen.

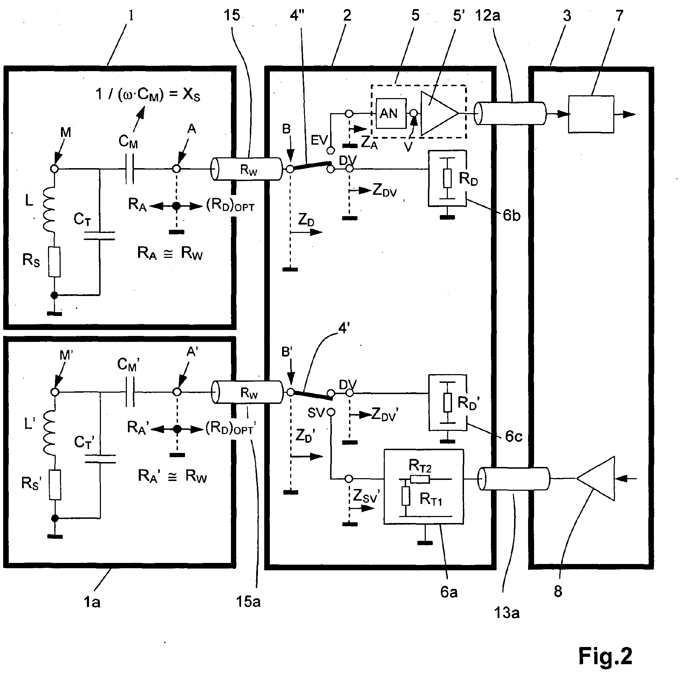

Fig. 2 zeigt eine alternative Ausführungsform, bei der neben dem HF-Schwingkreis 1 ein weiterer HF-Sendeschwingkreis 1 a vorgesehen ist, der im Wesentlichen gleich aufgebaut sein kann. Der HF-Schwingkreis 1 dient bei dieser Ausführungsform nur zur Detektion von FID-Signalen während des Empfangsvorgangs EV und während des Dämpfungsvorgangs DV und wird mit der passiven Dämpfungsimpedanz $Z_{DV}$ bedämpft, wobei das Umschalten vom Dämpfungsnetzwerk 6b für den Dämpfungsvorgang DV zum Vorverstärker 5 für den Empfangsvorgang EV mittels eines Schalters **4"** erfolgt. Für die Anregung des Spinsystems während des Sendevorganges SV hingegen ist der HF-Sendeschwingkreis 1 a vorgesehen, der vorzugsweise räumlich orthogonal zum HF-Schwingkreis 1 angeordnet ist und durch weitere passive Dämpfungsimpedanzen $\mathbf{Z_{SV}}'$, $\mathbf{Z_{DV}}'$ bedämpft werden kann. Auch hier ist ein Schalter **4'** vorgesehen, mit dem zu diesem Zweck zwischen dem Dämpfungsnetzwerk 6a für den Sendevorgang SV und einem Dämpfungsnetzwerk **6c** mit einem Dämpfungswiderstand $R_D'$ während des Dämpfungsvorgangs DV umgeschaltet werden kann. Die HF-Schwingkreise 1, 1a sind jeweils mit einer HF-Leitung 15, **15a** mit dem Vorverstärkermodul 2 verbunden. Während des Dämpfungsvorgangs DV verbinden beide Schalter 4", 4' die HF-Leitungen 15, 15a den HF-Schwingkreis 1 beziehungsweise den HF-Sendeschwingkreis 1a mit dem jeweiligen Dämpfungswiderstand $R_D$, $R_D'$ der Dämpfungsnetzwerke 6b, 6c.

Im Folgenden wird unter Bezugnahme auf **Fig. 3** detailliert auf eine mögliche Implementationsvariante eingegangen. Der HF-Schwingkreis 1 wird als Parallelschwingkreis der Kapazität $C_T$ und der Induktivität L mit dem Verlustwiderstand $R_S$ modelliert. Der HF-Schwingkreis 1 ist über den Koppelkondensator (Matchingkapazität) $C_M$ an 50 Ohm angepasst. Die Temperatur des HF-Schwingkreises 1 kann wesentlich tiefer liegen, als die Temperatur des folgenden Vorverstärker-Moduls 2. HF-Schwingkreis 1 und Vorverstärker-Modul 2 sind deshalb durch die HF-Leitung 15 örtlich und thermisch getrennt.

Zwei zur Schalteinrichtung gehörende Senderdioden **D1, D2** im Vorverstärker-Modul 2 leiten ein Eingangssignal 13b vom HF-Sender 8 (in Fig. 3 nicht gezeigt) während des Sendevorgangs SV in den HF-Schwingkreis 1. Durch die beiden Senderdioden D1, D2 fließt aufgrund einer Kontrollschaltung **10a** während des Sendevorgangs SV ein genügend großer Strom $I_{BIAS}$. Eine weitere Diode **D3** wird während des Sendevorgangs SV durch das Signal von einer weiteren Kontrollschaltung 9 ebenfalls mit einem in Durchlassrichtung angelegten DC-Strom betrieben so dass über eine λ/4 Leitung **16** die niederohmige Impedanz der Diode D3 zu einem Bezugspunkt **B** am vom HF-Schwingkreis 1 abgewandten Ende der HF-Leitung 15 zu einer hochohmigen Impedanz transformiert wird. Diese hochohmige Impedanz liegt parallel zum 50 Ohm System, welches die Senderdioden D1 und D2, sowie das Kabel 15 und den HF-Schwingkreis umfasst, und kann somit vernachlässigt werden, d.h. die hochohmige Impedanz hat dann keinen Einfluss auf das 50ohm System. Für den Fall einer nicht idealen Diode D3 ist eine weitere Diode **D4** als zusätzlicher Schutz des LNAs 5 vor Senderleistung vorgesehen.

Nach dem Senderpuls, wird mit Hilfe der Kontrollschaltungen 9, 10 schnellst möglichst auf den so genannten Dämpfungsvorgang DV umgeschaltet. Während des Sendevorgangs SV wird dem HF-Schwingkreis 1 so schnell wie möglich die Energie entzogen, also der Strom in der Induktivität L schnellst möglichst reduziert. Dies ist gleichbedeutend mit einer Maximierung des Realteils der Impedanz, durch welche die Induktivität L an einem hochohmigen Punkt **M**, belastet wird. Der Imaginärteil dieser Impedanz spielt nur eine vernachlässigbare Rolle, er bestimmt nur die Frequenz des Ausschwingsignals, aber nicht dessen Zeitkonstante. Es kann gezeigt werden, dass für hohe Güten der Induktivität L folgende Gleichung in Näherung gilt: $(R_D)_{OPT}$ = 1/ ($\omega \cdot C_M$). Mit anderen Worten, es gibt einen optimalen Widerstand $(R_D)_{OPT}$, welchen der HF-Schwingkreis 1 in Richtung des Vorverstärker-Moduls 2 am niederohmigen Anschlusspunkt A sehen sollte, so dass die Abklingzeit minimal wird. Dieser optimale Widerstand $(R_D)_{OPT}$ liegt je nach Güte der Induktivität L bei einigen kΩ. Mit dem Signal der Kontrollschaltung 9 wird nun die Diode D3 beaufschlagt, so dass sich deren hochfrequenter Seriewiderstand **R**$_{HF}$ zusammen mit der Transformierten der Eingangsimpedanz **Z**$_A$ des Verstärkers 5 über eine λ/4 Leitung **16** und die HF-Leitung 15 in die Nähe des, oder noch besser, genau auf $(R_D)_{OPT}$ transformiert. Gleichzeitig müssen die beiden Senderdioden D1 und D2 mittels einer genügend großen negativen Sperrspannung (Hochspannung = HV) gesperrt und somit genügend hochohmig geschalten werden, so dass sie durch starke Ausschwingsignale nicht automatisch in den leitenden und niederohmigen Zustand übergehen und somit $(R_D)_{OPT}$ störend beeinflussen.

Mit dieser Vorrichtung sieht der HF-Schwingkreis 1 für einige Mikrosekunden nach Anlegen des Senderpulses (Schalterstellung DV in der Kontrollschaltung 9 und 10a) eine Impedanz, bei welcher die Energie im HF-Schwingkreis 1 möglichst schnell abgeführt wird, das heißt es sind anschließend keine starken Ausschwingsignale mehr vorhanden, welche das Vorverstärker-Modul 2, den darin enthaltenen LNA 5 und/oder den folgenden HF-Empfänger 7(in Fig. 3 nicht gezeigt) übersteuern können. Ebenfalls sind die durch das Ausschwingsignal verursachten Basislinien Artefakte wesentlich kleiner.

Selbst während des Empfangsvorgangs EV, wenn die beiden Dioden D3, D4 sperren, kann die restliche Energie innerhalb des HF-Schwingkreises 1 schnell abgeführt werden, indem darauf geachtet wird, dass sich die Eingangsimpedanz $Z_A$ des LNAs 5 bis zum niederohmigen Anschlusspunkt A des HF-Schwingkreises 1 möglichst in die Nähe von $(R_D)_{OPT}$ transformiert. Dies ist in der Praxis machbar, da rauscharme GaAs-LNAs auch bei Rauschanpassung am Eingang sehr hochohmig sind. Bei der Dimensionierung des LNA 5, im Speziellen bei der Rauschanpassung des Anpassungsnetzwerks AN, liegt jedoch die Priorität ganz klar auf der Erreichung eines hohen SINOs und auf der Rauschanpassung des Vorverstärkers 5. Die Rauschanpassung des Vorverstärkers 5 lässt noch einen Freiheitsgrad offen, nämlich die Phase des Reflexionsfaktors am Eingang des Vorverstärkers 5., was durch eine eingangsseitige Kabellängenänderung der HF-Leitung 15 innerhalb des Vorverstärkers 5 kontrolliert werden kann. Somit kann ohne die Rauschanpassung zu verschlechtern die korrekte Eingangsimpedanz $Z_A$ des Anpassungsnetzwerkes AN und somit der bestmögliche Dämpfungswiderstand am niederohmiger Anschlusspunkt A während dem Empfangsvorgangs EV erreicht werden.

Es kann auch gezeigt werden, dass die bestmögliche Dämpfung des Ausschwingsignals während des Empfangsvorgangs EV gleichbedeutend ist mit einer minimalen Strahlungsdämpfung. Für minimale Strahlungsdämpfung während des Empfangsvorgangs EV, soll der Spulenstrom in der Induktivität L, welcher durch die induzierte Spannung entsteht, minimal sein. Dies ist der Fall, wenn der Absolutbetrag |Z+j*ω*L+R$_S$ maximal wird (Z ist die Impedanz vom Punkt M aus gesehen in Richtung der HF-Leitung 15). Das heißt, mit der gleichen Anordnung, mit welcher die Ausschwingzeit während des Empfangsvorgangs EV minimiert wird, wird auch die Strahlungsdämpfung während des Empfangsvorgangs EV minimiert. Durch minimale Strahlungsdämpfung und durch minimales Ausschwingsignal wird also der HF-Schwingkreis 1 elektronisch bedämpft, ohne SINO zu verlieren, da der LNA 5 immer noch rausch-angepasst ist. Durch diese optimale Bedämpfung wird als dritter Effekt eine verbesserte Empfangsbandbreite erreicht, wodurch das SINO von NMR Signalen an den Bandenden weniger beeinflusst wird.

**Fig. 4** zeigt einen HF-Schwingkreis 1' mit induktiver Ankopplung. Auch für solch eine Anordnung kann eine optimale Anpassung gefunden werden, so dass die Ausschwingzeit minimal wird. Der HF-Schwingkreis umfasst einen Kompensationskondensator **C$_k$,** mit dem der Blindanteil der induktiven Ankopplung L$_k$ (oder auch die primäre Streuinduktivität) kompensiert wird. Der Kompensationskondensator **C$_k$** ist jedoch nicht zwingend als physikalische Komponente erforderlich, diese Kompensation kann auch durch Verkürzen der HF-Leitung 15 erreicht werden. Es kann gezeigt werden, dass der optimale Widerstand bei dieser

Anordnung bei $(R_D)_{OPT}$ = ω·M liegt. Diese Anordnung ist schwieriger zu realisieren, als die Anordnung mit der kapazitiven Kopplung aus Fig. 3. Die Kompensation der primären Streuinduktivität ist für das Erreichen der minimalen Ausschwingzeit notwenig, da ansonsten der Strom in der induktiven Ankopplung L$_k$ unnötig begrenzt bleibt.

Des Weiteren kann auch gezeigt werden, dass falls der Dämpfungswiderstand R$_D$ ungleich der optimalen Impedanz $(R_D)_{OPT}$ ist, eine Schwebung im Ausschwingsignal entstehen kann. Eine einfache Erklärung dafür ist, dass die Ersatzschaltung des HF-Schwingkreises 1' ein Netzwerk vierter Ordnung darstellt, welches in dieser Topologie bei ungünstiger Dämpfung durch die optimale Impedanz $(R_D)_{OPT}$ zwei Resonanzen hat.

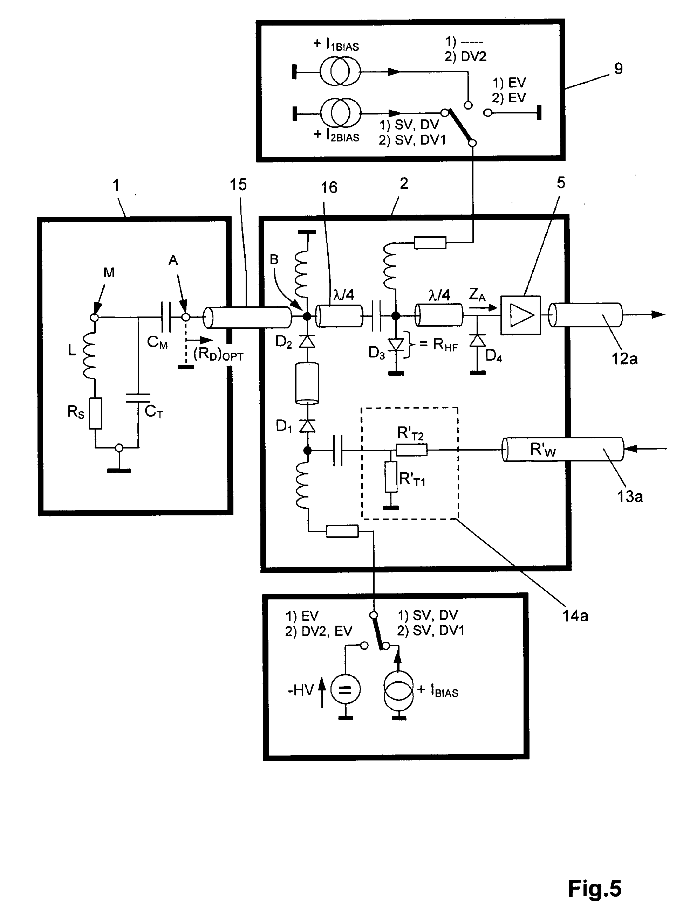

**Fig. 5** zeigt ein detailliertes Schaltbild einer weiteren Ausführungsform der erfindungsgemäßen MR-Detektionsanordnung, bei der wahlweise die Möglichkeit besteht, den HF-Schwingkreis durch eine Widerstandsgruppe $R'_{T1}$, $R'_{T2}$, R'w (R'w = Wellenwiderstand der HF-Eingangsleitung 13a sowie Ausgangsimpedanz des HF-Senders 8, typischerweise auch 50 Ohm) sowie durch den HF-Widerstand der Diode D3 optimal zu bedämpfen. Bei dieser Anordnung wird während des

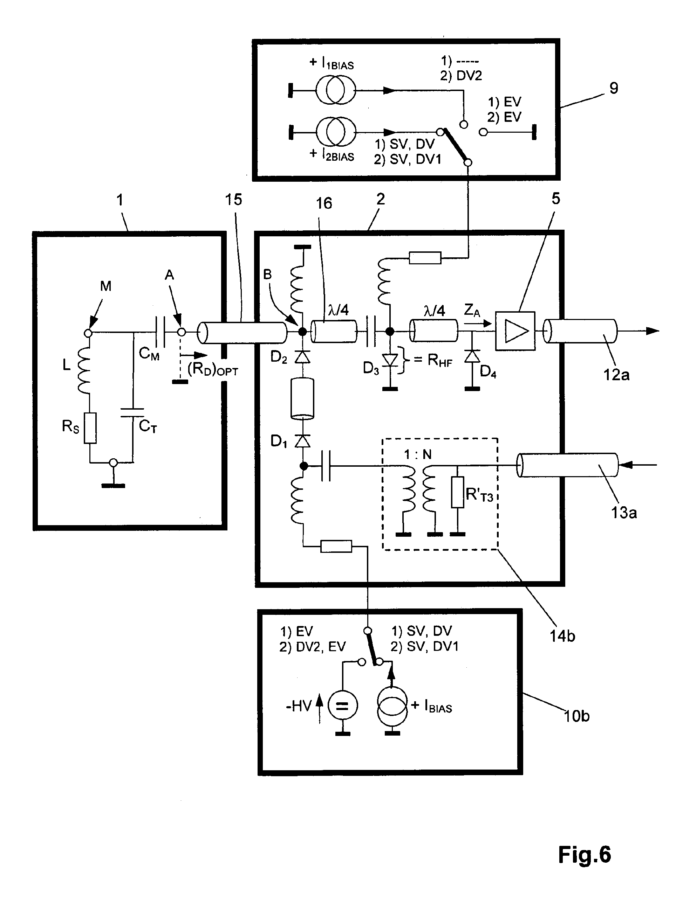

Sendevorgangs SV, die Anstiegszeit $\tau_{rise}$ des Stroms in der Induktivität L reduziert. Dies wird dadurch erreicht, indem der HF-Schwingkreis 1 während des Sendevorganges SV zusätzlich gedämpft wird, um seine Frequenz-Bandbreite auf den erforderlichen Wert zu vergrößern. Auch hier muss kein Eingriff in den HF-Schwingkreis 1 vorgenommen werden und das dazu notwendige Dämpfungsnetzwerk **14a** mit den Dämpfungswiderständen $R_{T1}$, $R_{T2}$ kann örtlich und thermisch getrennt vom HF-Schwingkreis 1 sein. Was während des Empfangsvorgangs EV möglich ist, ist auch während des Sendevorgangs SV möglich. Verlässt man die Leistungsanpassung beim Sendevorgang SV, so kann die Anstiegszeit des Spulenstroms dramatisch reduziert werden und zwar gleich wie beim Empfangsvorgang EV um den Q-Reduktionsfaktor. Auch hier existiert wiederum das gleiche Optimum. Mit den Dämpfungswiderständen $R'_{T1}$, $R'_{T2}$ wird die Impedanz $R'_W$ des HF-Senders 8 transformiert, so dass der HF-Schwingkreis 1 wiederum die optimale Impedanz $(R_D)_{OPT}$ sieht. Natürlich ist diese Anordnung nicht sehr leistungseffizient, da der größte Teil der Senderleistung in den Dämpfungswiderständen $R'_{T1}$ und $R'_{T2}$ "verheizt" wird. Die erforderliche Sendeleistung nimmt quadratisch zum Q-Reduktionsfaktor zu. Bei einer anderen Anordnung, bei welcher anstelle des Dämpfungswiderstands $R'_{T2}$ in einem Dämpfungsnetzwerk **14b** ein Transformator **(Fig. 6)** eingesetzt wird, nimmt die erforderliche Sendeleistung linear zum Q Reduktionsfaktor zu. Ein Dämpfungswiderstand $R'_{T3}$ ist immer noch notwendig, damit der HF-Sender 8 auf $R'_w$ (50 Ohm) angepasst ist. Würde also die Anstiegszeit um den Faktor 10 verkleinert, ist die notwenige Leistung zehnmal größer um den gleichen Spulenstrom zu erreichen. Dies ist bei einem HF-Schwingkreis 1 mit einem hohen Q-Wert problemlos vertretbar, da auch entsprechend dem hohen Q-Wert von niedrigeren Leistungen ausgegangen wird.

Als besonderer Vorteil ist hier auch zu erwähnen, dass der HF-Sender 8 bei korrekter Dimensionierung des Netzwerks trotz der Impedanztransformation an das Vorverstärker- Modul 2 angepasst bleibt. Somit treten auch keine unerwünschten Sendeabschaltungen oder -Ausfälle während des Sendevorgangs SV auf.

Dank der Erhaltung der Senderanpassung können weiterhin die normalen Verfahren zum Abstimmen des Probenkopfes über die HF-Eingangsleitung 13a verwendet werden. (Das Tuning/Matching, Wobbeln funktionieren für den Benutzer unverändert, das System verhält sich von außen her gesehen einfach so, wie wenn es einen niedrigeren Q-Wert hätte.) Falls für den Abstimmvorgang erforderlich, kann aber die, möglichst verlustfreie, Transformationsschaltung durch geringfügige Erweiterung des Systems auch überbrückt werden, was eine genauere Abstimmung erlaubt.

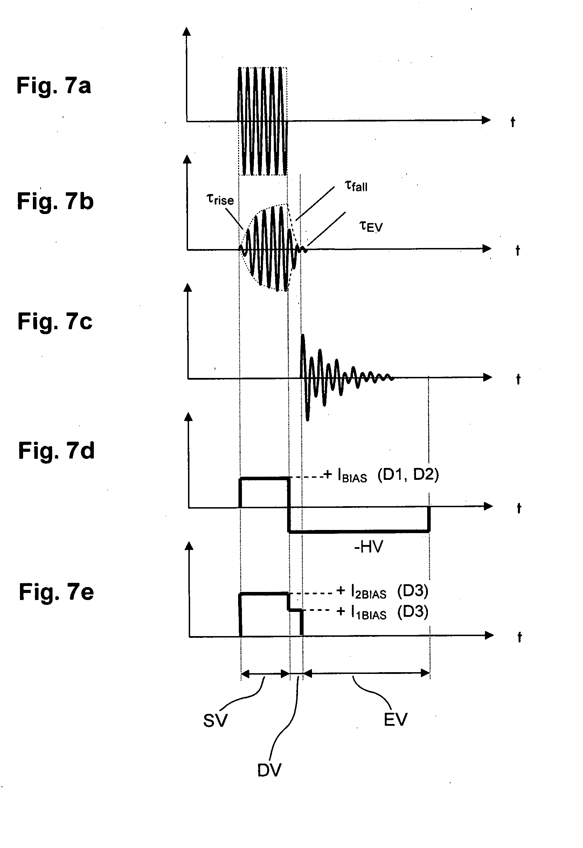

**Fig. 7a bis 7e** sind die zeitlichen Verläufe verschiedener Signale während des Sende-, Dämpfungs- und Empfangsvorganges bei der Schaltung von Fig. 3 oder Fig. 4 gezeigt. Der HF-Schwingkreis 1, 1' wird während des Dämpfungsvorganges DV mit Hilfe der Diode D3 optimal gedämpft, was zu einer kurzen Abfallzeit $\tau_{fall}$ führt. Eine zusätzliche Dämpfung während des Sendevorganges SV (z.B. mit den Widerständen $R'_{T1}$ und $R'_{T2}$ von Fig. 5) ist nicht vorhanden, so dass die Anstiegszeit $\tau_{rise}$ des Sendepulses relativ groß ist. Die weitere Abfallzeit während des Empfangsvorgangs EV ist mit $\tau_{EV}$ bezeichnet.

**Fig. 7a** zeigt den idealisierten Senderpuls, wie er vom HF-Sender 8 kommt. **Fig. 7b** zeigt den Strom in der Induktivität L, dieser Strom steigt exponentiell mit der Zeitkonstante $\tau_{rise}$ an. $\tau_{rise}$ ist abhängig von der Güte des HF-Schwingkreises 1, 1' und ergibt bei sendeseitiger Leistungsanpassung folgenden Wert: $\tau_{rise} = Q_L/\omega$, wobei $Q_L$ der Spulengüte entspricht und $\omega$ die Kreisfrequenz darstellt. Weil nach dem Sendevorgang SV während des Dämpfungsvorgangs DV der HF-Schwingkreis 1, 1' eine andere Impedanz als 50 Ohm sieht, ist auch die Zeitkonstante des abfallenden Signals unterschiedlich. Würde der HF-Schwingkreis 1, 1' mit einem Kurzschluss oder mit einem Open belastet, wäre die Fallzeit $\tau_{fall}$ =2* $\tau_{rise}$, würde der HF-Schwingkreis 1, 1' genau mit 50 Ohm belastet, wäre $\tau_{fall}$ = $\tau_{rise}$. Es kann gezeigt werden, dass es eine optimale Impedanz $(R_D)_{OPT}$ gibt, bei welcher $\tau_{fall}$ minimal wird. Es kann auch von einem Q-Reduktionsfaktor gesprochen werden, welcher das Verhältnis zwischen Spulengüte $Q_L$ und Güte des HF-Schwingkreises 1, 1' bei optimaler Impedanz während des Dämpfungsvorgangs DV angibt. Dieser Q Reduktionsfaktor berechnet sich folgendermaßen (Näherung für große $Q_L$):

$$\frac{Q_L}{Q_{reso}} = \frac{Q_L}{2 \cdot (\sqrt{\frac{Q_L \cdot R_{50}}{\omega \cdot L}} - 1)} + 1$$

$Q_L$: Spulengüte
$Q_{reso}$: Güte des HF-Schwingkreises während dem Dämpfungsvorgang
$R_{50}$: Systemimpedanz, üblicherweise 50 Ohm
L: Spuleninduktivität

Die Zeitkonstante $\tau_{fall}$ ist im optimalen Fall um den halben Q-Reduktionsfaktor kleiner als die Zeitkonstante $\tau_{rise}$.

**Fig. 7c** zeigt das NMR- beziehungsweise FID-Signal. In **Fig. 7d** und **7e** sind die Steuersignale für die drei Vorgänge SV, DV, EV dargestellt. Während des Sendevorgangs SV werden die Sendedioden D1 und D2 durchgestromt. Während dem Dämpfungsvorgang DV werden die Sendedioden D1 und D2 mit Hochspannung (=HV) gesperrt und die Diode D3 wird so durchgestromt, dass der HF-Schwingkreis 1, 1' mit der optimalen Impedanz $(R_D)_{OPT}$ belastet wird. Der Strom in der Diode D3 kann während dem Sende- und Dämpfungsvorgang SV, DV unterschiedlich sein, dies hat den Vorteil, dass während des Dämpfungsvorgangs DV der optimale HF Widerstand von der Diode D3 eingestellt werden kann. Während des Sendevorgangs SV wird hingegen die Diode D3 üblicherweise mit einem möglichst hohen Strom durchgestromt, damit sie möglichst niederohmig wird und einerseits den Vorverstärker 5 vor Überlastung schützt, andererseits wird damit der Punkt B möglichst hochohmig und somit wird der Sendevorgang SV nur minimal beeinflusst. Beim Empfangsvorgang EV wird der Strom $I_{BIAS}$ für die Diode D3 abgeschalten. Somit wird sie hochohmig und beeinflusst den Empfangsvorgang nicht.

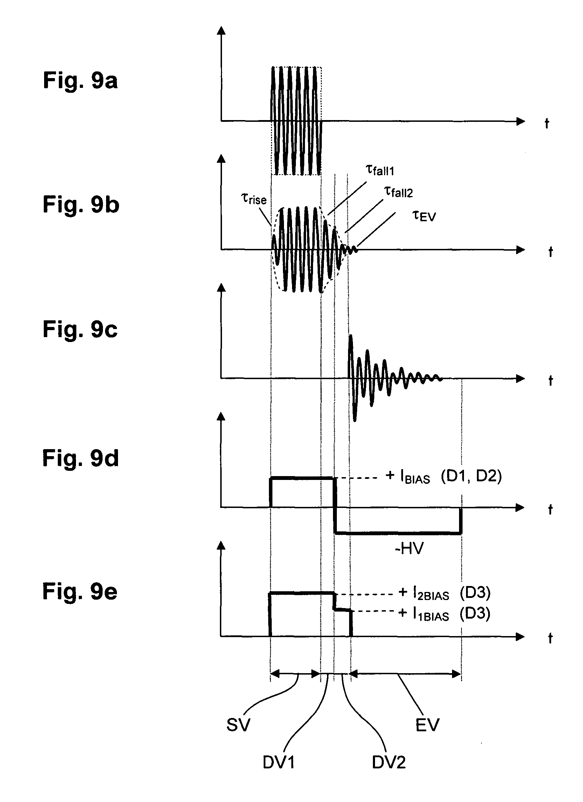

Gemäß **Fig. 9 a-e** kann auf die Vorteile einer expliziten Dämpfungsschaltung für die Dauer des Dämpfungsvorgangs zurückgegriffen werden. Dies hat den Vorteil, dass i.A. die explizite Dämpfungsvorrichtung mittels der Diode D3 etc. weiterhin eine optimal mögliche Dämpfung erreichen kann, währenddem die erreichbare Dämpfung durch die transformierte Sendeimpedanz wegen der damit verbundenen Einbussen an Leistungseffizienz beschränkt sein können.

Der eigentliche Dämpfungsvorgang wird somit in zwei Phasen aufgeteilt, welche für das Abklingen des HF-Schwingkreises 1, 1' auch zwei verschiedene Zeitkonstanten $\tau_{fall1}$, $\tau_{fall2}$ aufweisen. Fig. 9 a-e zeigen den zeitlicher Verlauf verschiedener Signale während des Sende-, Dämpfungs- und Empfangsvorganges bei einer solchen Ausführungsform der Schaltung von Fig. 5 oder Fig. 6. Der HF-Schwingkreis 1 wird während des Sendevorganges SV und während des ersten Teils **DV1** des Dämpfungsvorganges mit Hilfe der Dämpfungswiderstände $R'_{T1}$, $R'_{T2}$ resp. $R'_{T3}$ zusätzlich gedämpft, und während des zweiten Teils **DV2** des Dämpfungsvorganges mit Hilfe der Diode D3 optimal gedämpft.

Dadurch werden reduzierte Zeiten für die Anstiegszeit $\tau_{rise}$ und für die Abfallzeit $\tau_{fall}$ des Sendepulses erreicht. Während des Empfangsvorgangs EV klingt das restliche Signal mit $\tau_{EV}$ ab.

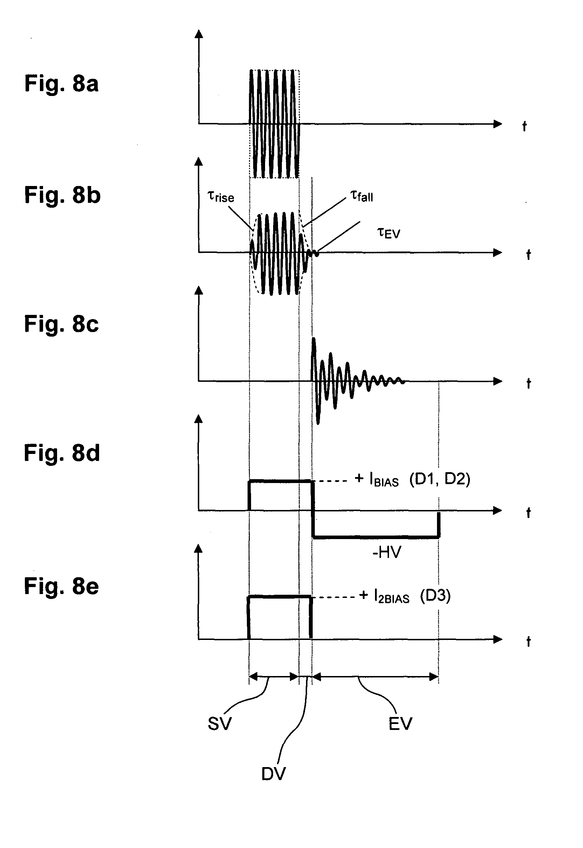

Alternativ kann aber insbesondere bei geringeren Anforderungen auf das Vorhandensein oder die Benutzung der expliziten Dämpfungsvorrichtung mittels der Diode D3 etc. verzichtet werden. **Fig. 8a-e** zeigen den zeitlicher Verlauf verschiedener Signale während des Sende-, Dämpfungs- und Empfangsvorganges bei dieser Ausführungsform oder Betriebsart der Schaltung von Fig. 5 oder Fig. 6. Der HF-Schwingkreis 1 wird sowohl während des Sendevorganges SV wie auch während des Dämpfungsvorganges DV mit Hilfe der Dämpfungswiderstände $R'_{T1}$, $R'_{T2}$ resp. $R'_{T3}$ gedämpft. Dadurch werden reduzierte Zeiten für die Anstiegszeit $\tau_{rise}$ und für die Abfallzeit $\tau_{fall}$ des Sendepulses erreicht. Während des Empfangsvorgangs klingt das restliche Signal mit $\tau_{EV}$ ab. Dabei wird während des Dämpfungsvorgangs DV lediglich der HF-Sendepuls abgeschaltet, was bereits zu einem automatisch gedämpften Abklingen des Stromes des HF-Schwingkreises 1, 1' führt (Fig. 8b). In den Fällen, in denen die Dämpfung mit dieser Betriebsart genügend groß ist, hat dies den Vorteil, dass einerseits die Komplexität des Systems und des Betriebs geringer wird. Zweitens, da die Anstiegs- und Abklingzeiten identisch sind, werden auch keine zusätzlichen Probleme in der Kalibrierung der verschiedenen Pulslängen auftreten (in der Praxis insbes. 90 vs. 180 vs. 360 Grad), da die Verzögerungen am Anfang und Ende des Pulses identisch sind und somit die Länge des Ausgangspulses (als Strom im HF-Schwingkreis 1, 1' stets weiterhin linear der Länge des Sendepulses entspricht.

Es ist ganz allgemein zu bemerken, dass bei hohen Dämpfungsfaktoren und langen HF-Leitungen 15 noch zusätzliche Effekte wegen der Eigenschaften der HF-Leitung 15 auftreten können. Diese können das maximal erreichbare Dämpfungsverhältnis zusätzlich beeinflussen und insbesondere auch reduzieren.

Dies kommt daher, dass die erwähnten Transformationseigenschaften der Leitungen nur für genau die Arbeits- bzw. Resonanzfrequenz gelten. Bei davon abweichenden Frequenzen treten andere, leicht abweichende Transformationen auf. Diese Effekte werden immer größer, je größer die Kabellänge im Verhältnis zur Wellenlänge wird. Sobald die Leitungslängen und die Dämpfungen so groß werden, dass diese Fehler innerhalb der gewünschten Bandbreite des gedämpften Systems signifikant werden, müssen sie bei der Auslegung des Gesamtsystems und der Optimierung der Komponenten mit berücksichtigt werden, um bestmögliche Ergebnisse zu erzielen.

**Referenzliste**

[1] "A probehead with switchable quality factor. Suppression of radiation damping"; C. Anklin, M. Rindlisbacher, G. Otting and F. H. Laukien; J. Magn. Res, B106, p199-201, 1995
[2] "Fast recovery, high sensitivity NMR probe and preamplifier for low frequencies"; D. I. Hoult; Rev. Sci. Instr. 50(2), Feb. 1979
[3] "Interplay among recovery time, signal, and noise: Series- and parallel-tuned circuits are not always the same"; J. B. Miller, B. H. Suits, A.N. Garroway, M. A. Hepp; Concepts in Magn. Res, vol 12, issue 3, p125-136
[4] "NMR Signal Reception: Virtual Photons and Coherent Spontaneous Emission"; D. I. Hoult, B. Bhakar; Concepts in Magn. Res, vol 9, issue 5, p 227-297

**Bezugszeichenliste**

| | |
|---|---|
| SV | Sendevorgang |
| DV | Dämpfungsvorgang |
| DV1 | erster Teilvorgang des Dämpfungsvorganges |
| DV2 | zweiter Teilvorgang des Dämpfungsvorganges |
| EV | Empfangsvorgang |
| AN | Anpassungsnetzwerk am Eingang des Vorverstärkers |
| A | niederohmiger Anschlusspunkt des HF-Schwingkreises |
| A' | niederohmiger Anschlusspunkt des HF-Sendeschwingkreises |
| B | Bezugspunkt am vom HF-Schwingkreis abgewandten Ende der HF-Leitung |
| HV | Hochspannung |
| M | hochohmiger Punkt der Induktivität des HF-Schwingkreises |
| M' | hochohmiger Punkt der Induktivität des HF-Sendeschwingkreises |
| V | Bezugspunkt im Vorverstärker zwischen dem Anpassungsnetzwerk und dem aktiven Teil des Vorverstärkers |
| $R_S$ | Verlustwiderstand der Resonanzinduktivität |
| $R_A$ | Die Transformierte der Verlustwiderstände des HF-Schwingkreises bezogen auf die niederohmige Anschlussstelle des HF-Schwingkreises |
| $R_Q$ | Dämpfungswiderstand des "Q-Switches" |
| $R_W$ | Wellenwiderstand der HF-Leitung 15 |
| $R'_W$ | Wellenwiderstand der HF-Eingangsleitung 13a sowie Ausgangs-impedanz des HF-Senders |
| $R_{HF}$ | HF-Widerstand der Diode D3 (Dieser HF-Widerstand ist vom DC-Strom $I_{BIAS}$ abhängig, der durch die Diode D3 fließt) |
| $R_D$ | Dämpfungswiderstand beim Dämpfungsvorgang (gehört zur Dämpfungsimpedanz $Z_{DV}$) |
| $R_D'$ | Dämpfungswiderstand beim Dämpfungsvorgang (gehört zur Dämpfungsimpedanz $Z_{DV'}$) |
| $(R_D)_{OPT}$ | Optimaler Dämpfungswiderstand am niederohmigen Anschlusspunkt des HF-Schwingkreises in Richtung der HF-Leitung gesehen |
| $(R_D)_{OPT}'$ | Optimaler Dämpfungswiderstand am niederohmigen Anschlusspunkt des HF-Sendeschwingkreises in Richtung der HF-Leitung gesehen |
| $R_{T1}$, $R_{T2}$ | Dämpfungswiderstände beim Sendevorgang, die zum Dämpfungs-netzwerk 6a gehören (sind Bestandteile der Dämpfungsimpedanz $Z_{SV}$) |
| $R'_{T1}$, $R'_{T2}$ | Dämpfungswiderstände beim Sendevorgang, die zum Dämpfungs-netzwerk 14a gehören |
| $R'_{T3}$ | Dämpfungswiderstand beim Sendevorgang, der zum Dämpfungs-netzwerk 14b mit Impedanztransformator gehört |
| L | Induktivität des HF-Schwingkreises |
| $L_K$ | induktive Ankopplung |
| $L_Q$ | Induktivität im HF-Schalter |
| $D_Q$ | Diode im HF-Schalter |
| $C_T$ | Resonanzkapazität des HF-Schwingkreises |
| $C_T'$ | Resonanzkapazität des HF-Sendeschwingkreises |
| $C_M$ | Koppelkondensator des HF-Schwingkreises |
| $C_M'$ | Koppelkondensator des HF- Sendeschwingkreises |
| $M_K$ | Gegeninduktivität der induktiven Ankopplung |
| $C_K$ | Kompensationskondensator der induktiven Ankopplung |
| $X_S$ | Blindwiderstand des Koppelkondensators $C_M$ ($X_S = 1 / (\omega C_M)$) |
| $Z_D$ | Dämpfungsimpedanz am Punkt B |
| $Z_D'$ | Dämpfungsimpedanz am Punkt B' |
| $Z_{DV}$ | Dämpfungsimpedanz beim Dämpfungsvorgang |
| $Z_{SV}'$ | Dämpfungsimpedanz beim Sendevorgang |
| $Z_{DV}'$ | Dämpfungsimpedanz beim Dämpfungsvorgang |
| $Z_A$ | Eingangsimpedanz des Anpassungsnetzwerkes AN inkl. Vorverstärker |
| D1 | Sendediode |
| D2 | Sendediode |
| D3 | Diode (Bestandteil der Schalteinrichtung) |
| D4 | Diode |
| $\tau_{rise}$ | Anstiegeszeit (Zeitkonstante) des Spulenstroms während des Sendevorgangs |
| $\tau_{fall}$ | Abfallzeit (Zeitkonstante) des Spulenstroms während des Dampfungsvorgangs |
| $\tau_{fall1}$, $\tau_{fall2}$, | Abfallzeit (Zeitkonstante) des Spulenstroms bei zwei aufeinander folgenden Teilvorgängen des Dämpfungsvorgangs |
| $\tau_{EV}$ | Abfallzeit (Zeitkonstante) des Spulenstroms während des Empfangsvorgangs |
| $I_{BIAS}$ | Strom innerhalb der Kontrollschaltung |
| $I_{1BIAS}$ | Strom innerhalb des HF-Senders |
| $I_{2BIAS}$ | Strom innerhalb des HF-Senders |
| $I^{11}_{BIAS}$ | Strom durch PIN-Diode |
| 1 | HF-Schwingkreis mit kapazitiver Ankopplung |
| 1' | HF-Schwingkreis mit induktiver Ankopplung |
| 100, 100' | HF-Schwingkreis |
| 1a | HF-Sendeschwingkreis |
| 2 | Vorverstärker-Modul |
| 3 | Sender/Empfänger-Modul |
| 4, 4', 4" | HF-Schalter im Vorverstärker-Modul |

| 5 | Vorverstärker (LNA) inklusive Anpassungsnetzwerk AN |
|---|---|
| 5' | Aktiver Teil des Vorverstärkers |
| 6a, 6c | Dämpfungsnetzwerk für den Sendevorgang |
| 6b | Dämpfungsnetzwerk für den Dämpfungsvorgang |
| 7 | HF-Empfänger |
| 8 | HF-Sender |
| 9 | Kontrollschaltung für die Diode D3. Mit der Diode D3 kann der Vorverstärker 5 hinzu- oder weggeschaltet werden. Zudem lässt sich mit dem HF-Widerstand $R_{HF}$ der Diode D3 die Dämpfung des HF-Schwingkreises während des Dämpfungsvorganges definieren. |
| 10a | Kontrollschaltung für die zur Schalteinrichtung gehörenden Sendedioden D1 und D2. Diese Sendedioden erlauben das Signal vom HF-Sender in den HF-Schwingkreis ein- oder auszuschalten. Dabei wird bei den Schaltungen von Fig. 5 und Fig. 6 zugleich auch eine zusätzliche Dämpfung des HF-Schwingkreises während des Sendevorganges erreicht, nämlich mit Hilfe der Widerstände $R'_{T1}$, $R'_{T2}$ resp. $R'_{T3}$. |
| 11 | HF-Schalter des "Q-Switches" |
| 12a | HF-Ausgangsleitung zum HF-Empfänger |
| 13a | HF-Eingangsleitung vom HF-Sender |
| 13b | Eingangssignal vom HF-Sender |
| 14a | Dämpfungsnetzwerk für den Sendevorgang (Dieses enthält die Dämpfungswiderstände $R'_{T1}$ und $R'_{T2}$) |
| 14b | Dämpfungsnetzwerk für den Sendevorgang (Dieses enthält den Dämpfungswiderstand $R'_{T3}$ sowie einen induktiven Impedanztransformator) |
| 15 | HF-Verbindungsleitung zwischen HF-Schwingkreis und Vorverstärker-Modul |
| 15a | HF-Verbindungsleitung zwischen HF-Sendeschwingkreis und Vorverstärker-Modul |
| 16, 17 | λ/4-Leitung |

## Patentansprüche

1. Magnetresonanz(=MR)-Detektionsanordnung mit mindestens einem HF-Schwingkreis (1, 1', 1a) mit einer Induktivität (L, L'), einem Vorverstärker-Modul (2) und einem HF-Empfänger (7), wobei zwischen einem hochohmigen Punkt (M M') der Induktivität (L, L'), des HF-Schwingkreises (1, 1', 1a) und einem niederohmigen Anschlusspunkt (A, A') des HF-Schwingkreises (1, 1', 1a) eine reaktive Transformationsschaltung angeschlossen ist, welche als Impedanztransformator wirkt und wobei der niederohmige Anschlusspunkt (A, A') des HF-Schwingkreis (1, 1', 1a) über eine HF-Leitung (15, 15a) mit einem Wellenwiderstand ($R_w$) mit dem Vorverstärker-Modul (2) verbunden ist, **dadurch gekennzeichnet, dass** im Vorverstärker-Modul (2) mindestens eine, der HF-Leitung (15, 15a) nachfolgende passive Dämpfungsimpedanz ($Z_{DV}$, $Z_{SV}$, $Z_{DV'}$, $Z_{SV'}$) vorgesehen ist, wobei die passive Dämpfungsimpedanz ($Z_{DV}$, $Z_{SV}$, $Z_{DV'}$, $Z_{SV'}$) während eines Dämpfungs-und/oder Sendevorgangs, bei dem von einem HF-Sender (8) HF-Pulsen zur Anregung eines Spinsystems an den HF-Schwingkreis (1, 1', 1a) gesendet werden, mittels mindestens einer Schalteinrichtung zu dem Schwingkreis (1, 1', 1a) zuschaltbar ist, und wobei der jeweilige Betrag des komplexen Reflexionsfaktors der passiven Dämpfungsimpedanz ($Z_{DV}$, Zsv, $Z_{DV'}$, $Z_{SV'}$) bezogen auf den Wellenwiderstand ($R_W$) der HF-Leitung (15, 15a) den Wert von 0.5 übersteigt.

2. MR-Detektionsanordnung nach Anspruch 1, **dadurch gekennzeichnet, dass** der HF-Schwingkreis (1, 1') zur Anregung des Spinsystems während des Sendevorgangs und zur Detektion von FID-Signalen während eines Empfangsvorgangs dient, wobei die Schalteinrichtung den HF-Schwingkreis (1, 1') während des Empfangsvorgangs mit dem HF-Empfänger (7) und während des Sendevorgangs mit dem HF-Sender (8) verbindet.

3. MR-Detektionsanordnung nach Anspruch 2, **dadurch gekennzeichnet, dass** die Schalteinrichtung einen dreiphasigen HF-Schalter (4, 4") umfasst.

4. MR-Detektionsanordnung nach Anspruch 1, **dadurch gekennzeichnet, dass** der HF-Schwingkreis (1, 1') nur zur Detektion von FID-Signalen während des Empfangsvorganges dient und während des Dämpfungsvorganges mit der passiven Dämpfungsimpedanz ($Z_{DV}$) bedämpft werden kann, wobei für die Anregung des Spinsystems während des Sendevorganges ein HF-Sendeschwingkreis (1 a) vorgesehen ist, der vorzugsweise räumlich orthogonal zum HF-Schwingkreis (1, 1') angeordnet ist, wobei mindestens eine weitere passive Dämpfungsimpedanz ($Z_{SV'}$, $Z_{DV'}$) während des Sende- und/oder Dämpfungsvorganges mit dem HF-Sendeschwingkreis (1a) verbunden sind, so dass der HF-Sendeschwingkreis (1a) mit der weiteren passiven Dämpfungsimpedanz ($Z_{SV'}$, $Z_{DV'}$) bedämpft werden kann.

5. MR-Detektionsanordnung nach einem der vorhergehenden Ansprüche, **dadurch gekennzeichnet, dass** zumindest eine der passiven Dämpfungsimpedanzen ($Z_{DV}$, $Z_{SV}$, $Z_{DV'}$, $Z_{SV'}$) so gewählt ist, dass am niederohmigen Anschlusspunkt (A) in Richtung der HF-Leitung (15) gesehen, eine optimale Impedanz ($R_D)_{OPT}$ vorliegt, welche die größte Dämpfung, und somit das schnellste Ausschwingen des HF-Schwingkreises (1') verursacht, wobei bei einer induktiven Transformationsschaltung, bei der der Blindanteil der Koppelinduktivität ($L_k$) kapazitiv mit einem Kondensator ($C_k$) kompensiert wird, $(R_D)_{opt}=\omega*M_k$ in guter Näherung gilt, wobei $M_k$ der Gegeninduktivität entspricht.

6. MR-Detektionsanordnung nach Anspruch 1 bis 4 **dadurch gekennzeichnet, dass** zumindest eine der Dämpfungsimpedanzen ($Z_{DV}$, $Z_{SV}$, $Z_{DV}$, $Z_{SV}$,) so gewählt ist, dass am niederohmigen Anschlusspunkt (A, A') in Richtung der HF-Leitung (15, 15') gesehen, eine optimale Impedanz ($R_D$)$_{OPT}$, ($R_D$)$_{OPT}$' vorliegt, welche die größte Dämpfung, und somit das schnellste Ausschwingen des HF-Schwingkreises (1, 1a) verursacht, wobei die reaktive Transformationsschaltung einen kapazitiven, Blindwiderstand ($X_S$) umfasst, der als Impedanztransformator wirkt, wobei die optimale Impedanz ($R_D$)$_{OPT}$, ($R_D$)$_{OPT}$' durch den Wert des Blindwiderstandes $X_S$ bestimmt wird, wobei in guter Näherung gilt ($R_D$)$_{OPT}$ = $X_S$.

7. MR-Detektionsanordnung nach einem der vorhergehenden Ansprüche, **dadurch gekennzeichnet, dass** ein Dämpfungsnetzwerk (6a, 14a, 14b) zur Erzeugung der zuschaltbaren passiven Dämpfungsimpedanz ($Z_{SV}$, $Z_{SV}$') vorgesehen ist, wobei das Dämpfungsnetzwerk (6a, 14a, 14b) einen Anschluss zu dem HF-Sender (8) aufweist, und dabei zur HF-Leitung (15, 15') fehlangepasst, zum HF-Sender (8) jedoch angepasst ist.

8. MR-Detektionsanordnung nach einem der vorhergehenden Ansprüche, **dadurch gekennzeichnet, dass** ein steuerbarer HF-Widerstand ($R_{HF}$), insbesondere eine PIN-Diode, zur Erzeugung der passiven Dämpfungsimpedanz ($Z_{DV}$, $Z_{SV}$, $Z_{DV}$, $Z_{SV}$') vorgesehen ist.

9. Verfahren zur Dämpfung eines HF-Schwingkreises (1, 1', 1a) einer MR-Detektionsanordnung nach einem der vorhergehenden Ansprüche, **dadurch gekennzeichnet, dass** während des Dämpfungs- und/oder des Sendevorganges eine Dämpfung des HF-Schwingkreises (1, 1', 1a) mit einer Zeitkonstantenreduktion größer als ein Faktor 2 erfolgt gegenüber einem Abschluss mit dem Wellenwiderstand ($R_W$) der HF-Leitung (15, 15') am niederohmigen Anschlusspunkt (A, A'), indem mittels der Schalteinrichtung die passive Dämpfungsimpedanz ($Z_{DV}$, $Z_{SV}$, $Z_{DV}$, $Z_{SV}$') zu dem Schwingkreis (1, 1', 1 a) zugeschaltet wird.

10. Verfahren nach Anspruch 9 zur Dämpfung eines HF-Schwingkreises (1, 1') einer MR-Detektionsanordnung nach Anspruch 2, **dadurch gekennzeichnet, dass** die Anregung des Spinsystems während des Sendevorganges und die Detektion des FID-Signals während des Empfangsvorganges mittels desselben HF-Schwingkreises (1, 1') erfolgen.

11. Verfahren nach Anspruch 9 zur Dämpfung eines HF-Schwingkreises (1, 1', 1a) einer MR-Detektionsanordnung nach Anspruch 4, **dadurch gekennzeichnet, dass** die Detektion des FID-Signals während des Empfangsvorganges mittels des HF-Schwingkreises (1, 1') und die Anregung des Spinsystems während des Sendevorganges mittels des HF-Sendeschwingkreises (1 a) erfolgen.

12. Verfahren nach einem der Ansprüche 9 bis 11 zur Dämpfung eines HF-Schwingkreises (1, 1', 1a) einer MR-Detektionsanordnung nach Anspruch 7, **dadurch gekennzeichnet, dass** die während des Sende- und/oder Dämpfungsvorgangs über die HF-Übertragungsleitung hinzu geschaltete passive Dämpfungsimpedanz ($Z_{DV}$, $Z_{SV}$, $Z_{DV}$, $Z_{SV}$') mittels des Dämpfungsnetzwerks (6a, 14a, 14b) erzeugt wird, welches am HF-Sender (8) angeschlossen ist und zur HF-Leitung (15, 15a) fehlangepasst, zum Sender jedoch angepasst wird.

13. Verfahren nach einem der Ansprüche 9 bis 12 zur Dämpfung eines HF-Schwingkreises (1, 1', 1a) einer MR-Detektionsanordnung nach Anspruch 8, **dadurch gekennzeichnet, dass** die optimale Impedanz ($R_D$)$_{OPT}$, ($R_D$)$_{OPT}$' mittels des steuerbaren HF-Widerstandes ($R_{HF}$) und der nachfolgenden Transformation am niederohmigen Anschlusspunkt (A, A') erzeugt wird.

Fig.1

**Fig.2**

**Fig.3**

**Fig.4**

**Fig.5**

Fig.6

Fig. 7a

Fig. 7b

$\tau_{rise}$    $\tau_{fall}$    $\tau_{EV}$

Fig. 7c

Fig. 7d

$+ I_{BIAS}$ (D1, D2)

$-HV$

Fig. 7e

$+ I_{2BIAS}$ (D3)

$+ I_{1BIAS}$ (D3)

SV    DV    EV

EP 1 887 373 A1

**Fig. 8a**

**Fig. 8b**

$\tau_{rise}$   $\tau_{fall}$   $\tau_{EV}$

**Fig. 8c**

**Fig. 8d**

---- + $I_{BIAS}$ (D1, D2)

-HV

**Fig. 8e**

---- + $I_{2BIAS}$ (D3)

SV   DV   EV

**Fig. 9a**

**Fig. 9b**

$\tau_{fall1}$

$\tau_{rise}$    $\tau_{fall2}$

$\tau_{EV}$

**Fig. 9c**

**Fig. 9d**

----- $+ I_{BIAS}$ (D1, D2)

-HV

**Fig. 9e**

----- $+ I_{2BIAS}$ (D3)
----- $+ I_{1BIAS}$ (D3)

SV      EV

DV1      DV2

**Stand der Technik**

**Fig.10**

**Stand der Technik**

**Fig.11a**

**Fig.11b**

**Stand der Technik**

**Europäisches**
**Patentamt**

**EUROPÄISCHER RECHERCHENBERICHT**

Nummer der Anmeldung

EP 07 01 5416

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | HOULT D I: "FAST RECOVERY WITH A CONVENTIONAL PROBE" JOURNAL OF MAGNETIC RESONANCE, ACADEMIC PRESS, LONDON, GB, Bd. 57, Nr. 3, 1984, Seiten 394-403, XP009053937 ISSN: 0022-2364 * das ganze Dokument * ----- | 1,2,4,5, 7-13 | INV. G01R33/36 |
| X | US 5 172 061 A (CROOKS LAWRENCE E [US] ET AL) 15. Dezember 1992 (1992-12-15) * Spalte 4, Zeile 39 - Spalte 11, Zeile 8 * * Abbildung 12 * ----- | 1-5,7-13 | |
| X | US 6 242 918 B1 (MILLER JOEL B [US] ET AL) 5. Juni 2001 (2001-06-05) * Spalte 3, Zeile 36 - Spalte 9, Zeile 45 * * Abbildungen 3-8 * ----- | 1,2,4,5, 7-13 | |
| | | | RECHERCHIERTE SACHGEBIETE (IPC) G01R A61B G01N G01V |

Der vorliegende Recherchenbericht wurde für alle Patentansprüche erstellt

| Recherchenort | Abschlußdatum der Recherche | Prüfer |
|---|---|---|
| München | 15. November 2007 | Streif, Jörg Ulrich |

EPO FORM 1503 03.82 (P04C03)

**EP 1 887 373 A1**

**ANHANG ZUM EUROPÄISCHEN RECHERCHENBERICHT
ÜBER DIE EUROPÄISCHE PATENTANMELDUNG NR.**

EP 07 01 5416

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-11-2007

| Im Recherchenbericht angeführtes Patentdokument | Datum der Veröffentlichung | Mitglied(er) der Patentfamilie | Datum der Veröffentlichung |
|---|---|---|---|
| US 5172061 A | 15-12-1992 | KEINE | |
| US 6242918 B1 | 05-06-2001 | KEINE | |

Für nähere Einzelheiten zu diesem Anhang : siehe Amtsblatt des Europäischen Patentamts, Nr.12/82

EPO FORM P0461

29

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **C. ANKLIN ; M. RINDLISBACHER ; G. OTTING ; F. H. LAUKIEN.** A probehead with switchable quality factor. Suppression of radiation damping. *J. Magn. Res,* 1995, vol. B106, 199-201
- **D. I. HOULT.** Fast recovery, high sensitivity NMR probe and preamplifier for low frequencies. *Rev. Sci. Instr.,* Februar 1979, vol. 50 (2
- **J. B. MILLER ; B. H. SUITS ; A.N. GARROWAY ; M. A. HEPP.** Interplay among recovery time, signal, and noise: Series- and parallel-tuned circuits are not always the same. *Concepts in Magn. Res,* vol. 12 (3), 125-136
- **D. I. HOULT ; B. BHAKAR.** NMR Signal Reception: Virtual Photons and Coherent Spontaneous Emission. *Concepts in Magn. Res,* vol. 9 (5), 227-297